# EUROPEAN PATENT APPLICATION

(11) **EP 4 821 774 A1**
(43) Date of publication of application: **14.10.2026**
(21) Application number: 25854865.0
(22) Date of filing: 12.08.2025
(51) Int. Cl.: B60W 20/14, B60W 10/06, B60W 10/08, B60W 30/18, B60K 6/26

(54) **APPARATUS AND METHOD FOR SETTING BATTERY POWER AND VEHICLE INCLUDING SAME**

(30) Priority: 12.08.2024 KR 20240107813; 12.08.2024 KR 20240107817; 12.08.2024 KR 20240107818
(71) Applicant: LG Energy Solution, Ltd., Seoul 07335 (KR)
(72) Inventor: GU, Min-Ji, Daejeon 34122 (KR); BAE, Yoon-Jung, Daejeon 34122 (KR); JEONG, Hee-Seok, Daejeon 34122 (KR); CHA, A-Ming, Daejeon 34122 (KR)
(74) Representative: Goddar, Heinz J.
(86) International application number: PCT/KR2025/012242
(87) International publication number: WO 2026/038868

(57) **Abstract**

The present disclosure provides a battery power setting apparatus for setting an upper limit power of a battery pack including one or more battery modules, each of which includes one or more battery cells, and the battery power setting apparatus includes a measurement unit configured to measure a voltage of each of the battery cells under a preset condition; and a control unit configured to determine a degradation level of each of the battery cells based on the voltage measured by the measurement unit, determine a degradation state of each of the battery modules based on the degradation level of the corresponding battery cell, and set an upper limit power of the battery pack according to the determined degradation state of the battery module.

## Description

### TECHNICAL FIELD

This application is based on and claims priority from Korean Patent Application Nos. 10-2024-0107813, 10-2024-0107817 and 10-2024-0107818, filed on August 12, 2024, with the Korean Intellectual Property Office, the disclosure of which is incorporated herein in its entirety by reference.

The present disclosure relates to a battery power setting apparatus and method, and a vehicle including the same.

### BACKGROUND ART

Traditionally, vehicles have used fuel cells as a power source. However, since performance degradation may occur in operating areas where fuel cell efficiency is low, hybrid electric vehicles have been developed that utilize both fuel cells and batteries as separate power sources. Furthermore, recently, along with the development of battery performance, electric vehicles that use batteries alone as a power source have become commercially available and in operation.

Currently, batteries used in electric vehicles are lithium batteries, which are secondary batteries that may be repeatedly charged and discharged. In the case of these secondary batteries, their performance gradually deteriorates due to phenomena such as deterioration that occur during the charging and discharging process as the period of use increases. The remaining life or degradation level of the battery over time may be indexed to estimate the battery SOH (State of Health), and depending on the degree of battery SOH (State of Health), the battery may need to be replaced or repaired. Battery SOH may be estimated by various methods based on various factors such as the battery's internal resistance, capacity, voltage, self-discharge, charging performance, and the number of charge and discharge cycles.

Meanwhile, if the maximum power that the battery can supply is supplied to the vehicle's driving unit, such as the motor, regardless of the battery's degradation level, the battery's degradation may be further accelerated. For example, if the maximum power that can be supplied to the motor when the battery's SOH is 100% in the initial state of the battery is supplied equally to the maximum power that can be supplied to the motor when the battery's SOH is less than 70% due to battery degradation, the degradation of the degraded battery may be further accelerated. Therefore, it is necessary to control the power supplied to the vehicle's motor according to the battery's degradation level.

### DISCLOSURE

### Technical Problem

The present disclosure is designed to solve the problems of the related art, and therefore the present disclosure is directed to providing a battery power setting apparatus and method that sets the output upper limit power of a battery pack by considering the degradation level of the battery.

In addition, the purpose is to provide a vehicle that may fully utilize the vehicle's driving performance while delaying battery degradation.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery power setting apparatus according to one aspect of the present disclosure sets an upper limit power of a battery pack including one or more battery modules, each of which includes one or more battery cells, the battery power setting apparatus comprising: a measurement unit configured to measure a voltage of each of the battery cells under a preset condition; and a control unit configured to determine a degradation level of each of the battery cells based on the voltage measured by the measurement unit, determine a degradation state of each of the battery modules based on the degradation level of the corresponding battery cell, and set an upper limit power of the battery pack according to the determined degradation state of the battery module.

The control unit may be configured to determine the degradation level of the battery cell as normal degradation, linear degradation, or accelerated degradation.

The control unit may be configured to determine the degradation state of each of the battery modules as a normal degradation state or an abnormal degradation state.

The control unit may be configured to calculate a voltage fluctuation rate based on the voltage of the battery cell and a preset reference voltage, calculate a voltage change rate of each battery cell based on the calculated voltage fluctuation rate and pre-stored voltage fluctuation rate data, and determine a degradation level of each battery cell based on the voltage change rate and a preset reference change rate.

The control unit may be configured to determine the degradation level as the normal degradation when the voltage change rate is 0 or a positive number, determine the degradation level as the linear degradation when the voltage change rate is a negative number and less than or equal to the reference change rate, and determine the degradation level as the accelerated degradation when the voltage change rate is a negative number and greater than the reference change rate.

The control unit may be configured to determine a degradation state of the battery module based on the number or ratio of battery modules whose degradation level is determined as the accelerated degradation.

The control unit may be configured to determine a power mode of the battery pack as a normal mode, a warning mode, or an emergency mode based on the number or ratio of battery modules whose degradation state is determined as the abnormal degradation state.

The control unit may be configured to set the upper limit power of the battery pack by weighting and adding a weight corresponding to the degradation state determined to correspond to an output enable power of each of the battery modules.

The power mode may be set so that a corresponding power decreases in the order of the normal mode, the warning mode, and the emergency mode.

The control unit may be configured to set the power corresponding to the determined power mode to the upper limit power of the battery pack.

The abnormal degradation state may be configured to include an abnormal degradation state or a complete degradation state based on the number or ratio of battery cells determined as the accelerated degradation.

The control unit may be configured to determine the power mode based on the number or ratio of battery modules whose degradation state is determined to be the abnormal degradation state or the complete degradation state.

The control unit may be configured to determine the degradation state of the battery module as the abnormal degradation state when the number of battery cells determined to be the accelerated degradation is greater than or equal to a first reference value or when the ratio is greater than or equal to a first rate.

The control unit may be configured to determine the degradation state of the battery module as the complete degradation state when the number of battery cells determined to be the accelerated degradation is greater than or equal to a second reference value greater than the first reference value or when the ratio is greater than or equal to a second rate greater than the first rate.

The control unit may be configured to decrease at least one of the first reference value, the first rate, the second reference value, and the second rate as the battery pack degrades.

A battery pack according to another aspect of the present disclosure may comprise the battery power setting apparatus according to one aspect of the present disclosure.

A vehicle according to still another aspect of the present disclosure may comprise: the battery power setting apparatus according to one aspect of the present disclosure; a battery pack having an upper limit power set by the battery power setting apparatus; and a driving control unit configured to control an output of the battery pack based on the upper limit power of the battery pack set by the battery power setting apparatus.

The driving control unit may be configured to limit a maximum output of a motor connected to the battery pack to an output corresponding to the upper limit power.

The driving control unit may be configured to limit the maximum output of the motor to correspond to the upper limit power after a preset time so as to correspond to a power mode of the battery pack, when an output request exceeding the upper limit power is input.

The driving control unit may be configured to obtain weather information, determine a weight corresponding to the obtained weather information from a preset table, add the determined weight to an output corresponding to the upper limit power, and limit an output of the motor to the weight-added output or less.

The driving control unit may be configured to obtain information about a target driving distance to a destination, a capacity of the battery pack, and a driving pattern of the vehicle, and control an operation of the motor based on the upper limit power, the capacity of the battery pack, the target driving distance, and the driving pattern.

The driving control unit may be configured to: calculate a first output value corresponding to the upper limit power, calculate a second output value to drive the target driving distance based on the capacity of the battery pack and the driving pattern, and limit the output of the motor to a smaller value of the first output value and the second output value or less.

The driving control unit may be configured to calculate the second output value so that the capacity of the battery pack becomes a preset threshold capacity or above when the target driving distance is reached, taking into account the driving pattern.

The driving control unit may be configured to control an output of the battery pack so that power is supplied to an essential element first within a range of the upper limit power, and power is supplied to an auxiliary element within a range of a remaining power.

The battery power setting apparatus may be configured to determine a power mode of the battery pack based on the determined degradation state of the battery module.

The driving control unit may be configured to control power distribution to the essential element and the auxiliary element based on the power mode of the battery pack.

A battery power setting method according to still another aspect of the present disclosure sets an upper limit power of a battery pack including one or more battery modules, each of which includes one or more battery cells, the battery power setting method comprising: a voltage measuring step of measuring a voltage of each of the battery cells under a preset condition; a battery cell degradation level determining step of determining a degradation level of each of the battery cells based on the voltage measured by the measurement unit, a battery module degradation state determining step of determining a degradation state of each of the battery modules based on the degradation level of the corresponding battery cell; and a battery pack upper limit power setting step of setting an upper limit power of the battery pack according to the determined degradation state of the battery module.

### Advantageous Effects

According to the battery power setting apparatus and method according to the present disclosure and the vehicle including the same, an upper limit power optimized for the battery pack may be set by considering the status of the battery cells and battery modules included in the battery pack. Therefore, since the output of the battery pack is limited by the upper limit power of the battery pack, there is an advantage in that degradation of the battery pack may be delayed.

The effects that can be obtained from the present disclosure are not limited to the effects mentioned above, and other effects that are not mentioned can be clearly understood by a person having ordinary skill in the art to which the present disclosure belongs from the description below.

### DESCRIPTION OF DRAWINGS

FIG. 1 is a schematic drawing of a battery power setting apparatus according to an embodiment of the present disclosure.
FIG. 2 is a schematic drawing of a battery pack according to another embodiment of the present disclosure.
FIG. 3 is a schematic drawing of a battery power setting method according to yet another embodiment of the present disclosure.
FIG. 4 is a schematic drawing of a vehicle according to yet another embodiment of the present disclosure.
FIG. 5 and FIG. 6 are schematic drawings of a vehicle control method according to yet another embodiment of the present disclosure.
FIG. 7 and FIG. 8 are schematic drawings of a vehicle control method according to yet another embodiment of the present disclosure.
FIG. 9 is a perspective view of a hybrid electric vehicle according to one embodiment.
FIG. 10 is an exploded perspective view of the hybrid electric vehicle according to FIG. 9.
FIG. 11 is a drawing showing in detail the configuration of the hybrid electric vehicle according to FIG. 10.
FIG. 12 is a perspective view showing the first battery according to FIG. 11.
FIG. 13 is a perspective view showing the battery module of the first battery of FIG. 12.
FIG. 14 is a perspective view showing the exterior of the battery cell of FIG. 13.
FIG. 15 is an exploded perspective view of the battery cell of FIG. 14.
FIG. 16 is a drawing showing the specific configuration of the electric control unit according to FIG. 11.
FIG. 17 is a diagram showing the relationships between components of the electric control unit in an EV driving mode.
FIG. 18 is a diagram showing the relationships between components of a hybrid electric vehicle in an EV driving mode.
FIG. 19 is a diagram showing the relationships between components of the electric control unit in a HEV driving mode.
FIG. 20 is a diagram showing the relationships between components of a hybrid electric vehicle in a HEV driving mode.
FIG. 21 is a diagram showing the relationships between components of the electric control unit in an ENG driving mode.
FIG. 22 is a diagram showing the relationships between components of a hybrid electric vehicle in an ENG driving mode.
FIG. 23 is a diagram showing the relationships between components of the electric control unit in a RB driving mode.
FIG. 24 is a diagram showing the relationship between the components of a hybrid electric vehicle in a RB driving mode.
FIG. 25 is a detailed diagram illustrating in detail the configuration of a hybrid electric vehicle according to one embodiment.
FIG. 26 is a diagram illustrating the measurement of the open circuit voltage of a battery cell using the battery management system according to FIG. 25.
FIG. 27 is a flowchart illustrating a driving mode control method based on the degradation state of the first battery of a hybrid electric vehicle according to one embodiment.
FIG. 28 is a flowchart illustrating more detailed steps of FIG. 27.
FIG. 29 is a graph illustrating driving mode control in a normal mode of FIG. 28.
FIG. 30 is a graph illustrating driving mode control in a warning mode of FIG. 28.
FIG. 31 is a graph illustrating driving mode control in an emergency mode of FIG. 28.
FIG. 32 is an exploded perspective view of a hybrid electric vehicle according to another embodiment.
FIG. 33 is a drawing showing in detail the configurations of the hybrid electric vehicle according to FIG. 32.
FIG. 34 is a drawing showing the specific configurations of the electric control unit according to FIG. 33.
FIG. 35 is a drawing showing the relationships between the components of the electric control unit in an EV driving mode.
FIG. 36 is a drawing showing the relationships between the components of the hybrid electric vehicle in an EV driving mode.
FIG. 37 is a drawing showing the relationships between the components of the electric control unit in a HEV driving mode.
FIG. 38 is a drawing showing the relationships between the components of the hybrid electric vehicle in a HEV driving mode.
FIG. 39 is a drawing showing the relationships between the components of the electric control unit in an ENG driving mode.
FIG. 40 is a diagram showing the relationships between components of a hybrid electric vehicle in an ENG driving mode.
FIG. 41 is a diagram showing the relationships between components of an electric control unit in a RB driving mode.
FIG. 42 is a diagram showing the relationships between components of a hybrid electric vehicle in a RB driving mode.
FIG. 43 is a schematic diagram showing repair or replacement of the secondary battery in the hybrid electric vehicle according to FIG. 32.
FIG. 44 is a diagram showing in detail the components of a hybrid electric vehicle according to another embodiment.
FIG. 45 is a schematic diagram showing repair or replacement of a secondary battery in the hybrid electric vehicle according to FIG. 44.

### BEST MODE

The advantages and features of the present disclosure, and the methods for achieving them, will become clear with reference to the embodiments described in detail below together with the accompanying drawings. However, the present disclosure is not limited to the embodiments disclosed below, but may be implemented in various different forms, and the embodiments are provided only to allow the scope of the disclosure to be completely and fully understood by those skilled in the art, and the present disclosure is defined only by the scope of the claims. Like reference signs refer to like elements throughout the specification.

When one component is referred to as being "connected to" or "coupled to" another component, it includes both cases where it is directly connected or coupled to the other component or cases where there is another component intervening them. Conversely, when one component is referred to as being "directly connected to" or "directly coupled to" another component, it indicates that there is no other component intervening them. The expression "and/or" includes each of the mentioned items and at least one every combination thereof.

The terminology used herein is for the purpose of describing embodiments only and is not intended to be limiting of the present disclosure. In this specification, the singular also includes the plural unless the context clearly dictates otherwise. The terms "comprise" and/or "comprising" as used herein do not exclude the presence or addition of at least one other component, step, operation, and/or element.

Although terms such as first, second, etc. are used to describe various components, these components are not limited by these terms. These terms are used only to distinguish one component from another.

Therefore, it goes without saying that the first component mentioned below may also be the second component within the technical concept of the present disclosure. Unless otherwise defined, all terms (including technical and scientific terms) used herein may be used with a meaning that can be commonly understood by those of ordinary skill in the technical field to which the present disclosure belongs. In addition, terms defined in commonly used dictionaries shall not be interpreted ideally or excessively unless explicitly and specifically defined.

The steps of a method or algorithm described in connection with some embodiments of the present disclosure may be implemented directly in hardware, a software module, or a combination thereof, executed by a processor. The software module may reside in a RAM memory, a flash memory, a ROM memory, an EPROM memory, an EEPROM memory, registers, a hard disk, a removable disk, a CD-ROM, or any other form of storage medium known in the art. An exemplary storage medium is coupled to the processor, such that the processor can read information from, and write information to, the storage medium. Alternatively, the storage medium may be integral to the processor. The processor and the storage medium may reside in an application-specific integrated circuit (ASIC). The ASIC may reside in a user terminal.

Hereinafter, with reference to the attached drawings, embodiments of the present disclosure will be described in detail so that those skilled in the art can easily implement the present disclosure. However, the present disclosure may be implemented in various different forms and is not limited to the embodiments described herein.

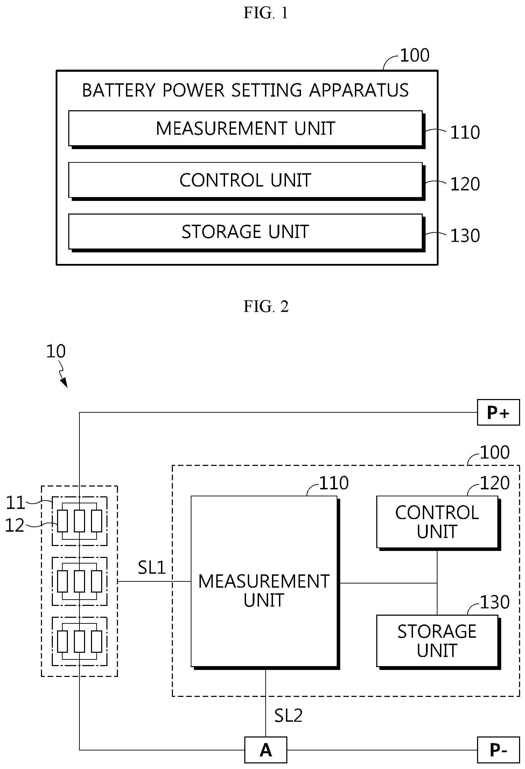

FIG. 1 is a schematic drawing of a battery power setting apparatus 100 according to an embodiment of the present disclosure.

The battery pack 10 may include at least one battery module 11. For example, a plurality of battery modules 11 may be electrically connected to each other in series and/or in parallel. And, the battery module 11 may include one or more battery cells 12. Similarly, a plurality of battery cells 12 may be electrically connected to each other in series and/or in parallel.

Here, the battery cell 12 has a negative electrode terminal and a positive electrode terminal, and means a physically separable independent cell. For example, a lithium-ion battery or a lithium polymer battery may be considered as the battery. In addition, the type of battery cell may be a cylindrical type, a prismatic type, or a pouch type.

Referring to FIG. 1, the battery power setting apparatus 100 may include a measurement unit 110 and a control unit 120.

The measurement unit 110 may be configured to measure the voltage of each of the battery cells 12 under preset conditions.

Specifically, the measurement unit 110 may be electrically connected to each of the battery cells 12. And, the measurement unit 110 may measure the voltage of each of the battery cells 12.

In addition, the measurement unit 110 may be configured to measure the voltage of the battery cell 12 and measure the OCV (Open circuit voltage) of the battery cell 12 when the measured voltage satisfies a preset condition. Specifically, the measurement unit 110 may measure the OCV when the battery is in an idle state, if the voltage of the battery cell 12 reaches a preset voltage.

Here, the preset voltage is a voltage value that is commonly applied to all battery cells 12 included in the battery pack 10 and is preset to unify the OCV measurement time point. For example, the preset voltage may be set to a discharge end voltage or charge end voltage of a plurality of battery cells 12. As another example, the preset voltage may be preset to a specific voltage (e.g., 2.8 [V] to 4.2 [V]) included in the voltage range of the battery cells 12.

The measurement unit 110 may be connected to the control unit 120 via a wire and/or wireless connection to enable communication. In addition, the measurement unit 110 may transmit information about the measured voltage of the battery cell 12 to the control unit 120.

The control unit 120 may be configured to determine the degradation level of each battery cell 12 based on the voltage measured by the measurement unit 110.

Specifically, the control unit 120 may determine the degradation level of the battery cell 12 based on the ratio (voltage change rate) at which the voltage fluctuation rate (voltage difference or voltage ratio) between the voltage of the battery cell 12 and a preset reference voltage changes over time (as cycles elapse).

As the cycle elapses, the voltage change rate of the voltage fluctuation rate of the battery cell 12 may increase, remain constant, or decrease.

For example, if the voltage fluctuation rate between the voltage of the battery cell 12 and the reference voltage increases as the number of cycles elapses, the voltage change rate may increase. In this case, the control unit 120 may determine the degradation level of the battery cell 12 as normal degradation.

As another example, if the voltage fluctuation rate between the voltage of the battery cell 12 and the reference voltage remains the same or with no significant difference even after the cycle has elapsed, the voltage change rate may be maintained at a certain level. In this case, the control unit 120 may determine the degradation level of the battery cell 12 as normal degradation.

As still another example, if the voltage fluctuation rate between the voltage of the battery cell 12 and the reference voltage becomes smaller as the cycle passes, the voltage change rate may decrease. In this case, the control unit 120 may determine the degradation level of the battery cell 12 as linear degradation or accelerated degradation.

Here, the normal degradation, the linear degradation, and the accelerated degradation refer to the degradation states of the battery cell 12 determined in terms of degradation speed. The normal degradation refers to a state in which the battery cell 12 does not experience performance degradation compared to the BOL (Beginning of Life) state. The linear degradation refers to a state in which the degradation of the battery cell 12 is not accelerated but progresses linearly. The accelerated degradation refers to a state in which the degradation of the battery cell 12 is gradually accelerated.

That is, the control unit 120 may determine the degradation level of each battery cell 12 by considering the increase/decrease pattern of the voltage fluctuation rate between the voltage of the battery cell 12 and the reference voltage. A specific embodiment in which the control unit 120 determines the degradation level of each battery cell 12 is described below.

The control unit 120 may be configured to determine the degradation state of each battery module 11 based on the degradation level of the corresponding battery cell 12.

Specifically, the battery module 11 may include one or more battery cells 12. That is, control unit 120 may determine the degradation state of the battery module 11 by synthesizing the degradation levels of all battery cells 12 included in the battery module 11.

The degradation state of the battery module 11 may be determined based on whether the battery module 11 is degrading normally, and the control unit 120 may be configured to determine the degradation state of each battery module 11 as a normal degradation state or an abnormal degradation state.

As described above, the battery cells 12 with a degradation level of accelerated degradation are degrading more and more rapidly, while the battery cells 12 with a degradation level of linear degradation are degrading linearly at a predictable level. Therefore, the control unit 120 may determine the degradation state of the corresponding battery module 11 based on the number or ratio of battery cells 12 whose degradation level is determined as accelerated degradation among the battery cells 12 included in the battery module 11.

That is, as more battery cells 12 whose degradation level is determined to be accelerated degradation are included, the degradation state of the corresponding battery module 11 may be determined to be an abnormal degradation state. A specific embodiment in which the control unit 120 determines the degradation state of the battery module 11 will be described later.

The control unit 120 may be configured to set the upper limit power of the battery pack 10 according to the determined degradation state of the battery module 11.

In one embodiment, the control unit 120 may determine the power mode of the battery pack 10 as a normal mode, a warning mode, or an emergency mode according to the determined degradation state of the battery module 11. In addition, the power mode may be preset so that the corresponding power decreases in the order of the normal mode, the warning mode, and the emergency mode. That is, the control unit 120 may determine the power mode of the battery pack 10, and set the power preset to correspond to the determined power mode as the upper limit power of the battery pack 10.

In another embodiment, the upper limit power of the battery pack 10 may be set based on the output enable power of the battery module 11 included in the battery pack 10. That is, the upper limit of the output of the battery pack 10 is the sum of the maximum outputs of all the battery modules 11 included in the battery pack 10. Therefore, in order to set the upper limit power of the battery pack 10, the output of each battery module 11 included in the battery pack 10 must be considered.

For example, it is assumed that the battery pack 10 includes n battery modules 11 connected in series, and that the output of each battery module 11 is m. In this case, the upper limit power of the battery pack 10 may be set according to the formula "n × m".

Preferably, the control unit 120 may determine the output of each battery module 11 by considering the degradation state of the battery module 11. For example, the control unit 120 may determine the output of each battery module 11 by using a weight determined to correspond to the degradation state.

Specifically, the control unit 120 may be configured to set the upper limit power of the battery pack 10 by weighting and adding weights corresponding to the degradation states determined to correspond to the output enable power of each battery module 11.

Assuming that there are a total of n battery modules 11 connected in series in the battery pack 10, the upper limit power of the battery pack 10 may be set using the following formula. [Formula] ${P}_{upper} = {\sum }_{k = 1}^{n} {w}_{k} \times {P}_{k}$

Here, Pᵤₚₚₑᵣ [kWh] is the upper limit power of the battery pack 10, Pₖ [kWh] is the output of the kth battery module 11, and wₖ is the weight corresponding to the degradation state of the kth battery module 11.

The battery power setting apparatus 100 according to an embodiment of the present disclosure may set an upper limit power optimized for the battery pack 10 by considering the degradation level of the battery cell 12 included in the battery pack 10 and the degradation state of the battery module 11. Accordingly, over-discharging of the battery pack 10 and acceleration of degradation of the battery cell 12 and the battery module 11 may be prevented.

Meanwhile, the control unit 120 provided in the battery power setting apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery power setting apparatus 100 may further include a storage unit 130. The storage unit 130 may store data necessary for operation and function of each component of the battery power setting apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by each component of the battery power setting apparatus 100 are defined.

Below, an embodiment in which the control unit 120 determines the degradation level of the battery cell 12 is specifically described.

The control unit 120 may be configured to calculate a voltage fluctuation rate based on the voltage of the battery cell 12 and a preset reference voltage.

Specifically, the reference voltage may be the OCV of the battery cell 12 in the BOL state or a voltage value set theoretically/experimentally.

For example, it is assumed that the measurement unit 110 measures the OCV of the battery cell 12 when the voltage of the battery cell 12 reaches the charge end voltage (or discharge end voltage). The reference voltage is the OCV of the battery cell 12 measured when the voltage of the battery cell 12 in the BOL state reaches the charge end voltage (or discharge end voltage).

As another example, the reference voltage may be preset to the OCV of a reference cell preset to correspond to the battery cell 12 or a reference cell determined theoretically/experimentally through simulation, etc., rather than the battery cell 12 in the BOL state.

Assume that the voltage of the battery cell 12 of the kth battery is Vₖ [V] and the reference voltage is V_{ref} [V]. The control unit 120 may calculate the voltage fluctuation rate of the kth battery cell 12 by calculating the formula "Vₖ - V_{ref}" or "Vₖ ÷ V_{ref}".

The control unit 120 may be configured to calculate the voltage change rate of each battery cell 12 based on the calculated voltage fluctuation rate and pre-stored voltage fluctuation rate data.

Here, the voltage fluctuation rate data is reference data for comparison with the calculated voltage fluctuation rate, and may be data in which the calculated values of the voltage change rate are stored for each cycle. Specifically, the pre-stored voltage fluctuation rate data is data in which the voltage fluctuation rates of the battery cell 12 calculated in the past are stored for each cycle. For example, if the current cycle is the sth cycle, the voltage fluctuation rate of the battery cell 12 from the first cycle to the s-1-th cycle may be stored in the voltage fluctuation rate data.

The control unit 120 may calculate the voltage change rate based on the calculated voltage fluctuation rate and the past voltage fluctuation rate stored in the voltage fluctuation rate data.

Specifically, the control unit 120 may calculate a voltage change rate for the voltage fluctuation rate included in the cycle section selected based on the current cycle. Here, the voltage change rate may be an average change rate of a plurality of voltage fluctuation rates included in the selected cycle section or an instantaneous change rate of the voltage fluctuation rate of the current cycle in a predetermined cycle section. In other words, the voltage change rate is an indicator indicating an increase or decrease in the voltage fluctuation rate in the predetermined cycle section. Preferably, the voltage change rate may be calculated as 0, a positive number, or a negative number.

For example, it is assumed that the control unit 120 has selected the last 10 cycles including the current cycle. The control unit 120 may calculate the voltage change rate of the voltage fluctuation rate for the 10 cycles.

The control unit 120 may be configured to determine the degradation level as normal degradation when the voltage change rate is 0 or a positive number.

If the voltage change rate is 0, the cycle has elapsed, but the voltage fluctuation rate of the battery cell 12 remains the same. That is, since the voltage fluctuation rate between the voltage of the battery cell 12 and the reference voltage does not increase or decrease but is constant, the control unit 120 may determine the degradation level of the battery cell 12 as normal degradation. Specifically, the control unit 120 may determine the voltage increase/decrease pattern of the battery cell 12 as a voltage constant pattern and determine the degradation level of the battery cell 12 as normal degradation.

If the voltage change rate is a positive number, the voltage fluctuation rate of the battery cell 12 increases as the cycle elapses. That is, since the OCV of the battery cell 12 is not decreasing, the control unit 120 may determine the degradation level of the battery cell 12 as normal degradation. Specifically, the control unit 120 may determine the voltage increase/decrease pattern of the battery cell 12 as a voltage increase pattern and determine the degradation level of the battery cell 12 as normal degradation.

If the voltage change rate is a negative number, the voltage fluctuation rate of the battery cell 12 decreases as the cycle elapses. That is, since the OCV of the battery cell 12 is decreasing, the control unit 120 may determine the degradation level of the battery cell 12 as linear degradation or accelerated degradation. Specifically, the control unit 120 may determine the voltage increase/decrease pattern of the battery cell 12 as a voltage decrease pattern, and determine the degradation level of the battery cell 12 as linear degradation or accelerated degradation.

Here, in order to distinguish between linear degradation and accelerated degradation, the control unit 120 may be configured to determine the degradation level of each battery cell 12 based on a voltage change rate and a preset reference change rate. That is, the preset reference voltage change rate is a reference change rate set to determine the degradation level as accelerated degradation or linear degradation when the voltage increase/decrease pattern of the battery cell 12 is determined as a voltage decrease pattern.

For example, the control unit 120 may be configured to determine the degradation level as linear degradation when the voltage change rate is a negative number and less than or equal to the reference change rate. As another example, the control unit 120 may be configured to determine the degradation level as accelerated degradation when the voltage change rate is a negative number and greater than the reference change rate.

That is, the battery power setting apparatus 100 does not uniformly determine the degradation level of the battery cell 12 based on the voltage increase/decrease pattern of the battery cell 12, but rather compares the voltage change rate of the battery cell 12 with the reference voltage change rate to specifically determine the degradation level of the battery cell 12. Therefore, there is an advantage in that the current status of the battery cell 12 may be diagnosed in more detail and specific manner.

Below, an embodiment in which the control unit 120 determines the degradation state of the battery module 11 is specifically described.

As described above, the degradation state of the battery module 11 may be determined based on the degradation level of the included battery cell 12.

The control unit 120 may be configured to determine the degradation state of each battery module 11 based on the number or ratio of battery cells 12 whose degradation level is determined to be accelerated degradation.

First, the control unit 120 may determine the degradation state of the battery module 11 as a normal degradation state or an abnormal degradation state depending on whether there is a battery cell 12 whose degradation level is determined to be accelerated degradation.

For example, if the battery module 11 includes only a battery cell 12 whose degradation level is determined to be normal degradation or linear degradation, the control unit 120 may determine the degradation state of the battery module 11 as a normal degradation state. Conversely, if the battery module 11 includes a battery cell 12 whose degradation level is determined to be accelerated degradation, the control unit 120 may determine the degradation state of the battery module 11 as an abnormal state.

In addition, the control unit 120 may further determine the abnormal degradation state as an abnormal degradation state or a complete degradation state. More specifically, the abnormal degradation state may be configured to include an abnormal degradation state or a complete degradation state based on the number or ratio of battery cells 12 determined as accelerated degradation.

For example, the control unit 120 may be configured to determine the degradation state of the battery module 11 as an abnormal degradation state when the number of battery cells 12 determined to be accelerated degradation is greater than or equal to the first value or when the ratio is greater than or equal to the first rate.

As another example, the control unit 120 may be configured to determine the degradation state of the battery module 11 as a complete degradation state when the number of battery cells 12 determined to be accelerated degradation is greater than or equal to the second value greater than the first value or when the ratio is greater than or equal to the second rate greater than the first rate.

That is, the control unit 120 may determine the degradation state of each battery module 11 as a normal degradation state, an abnormal degradation state, or a complete degradation state based on the number or ratio of battery cells 12 whose degradation level is determined as accelerated degradation.

The battery power setting apparatus 100 has the advantage of being able to independently determine the degradation state of each battery module 11 by determining the degradation state of the battery module 11 based on the degradation level of the included battery cell 12.

Meanwhile, the control unit 120 may be configured to decrease at least one of the first reference value, the first rate, the second reference value, and the second rate as the battery pack 10 degrades.

That is, the control unit 120 may more strictly determine the degradation state of the battery module 11 by reducing the size of the reference value that determines the degradation state of the battery module 11 as the battery pack 10 is used more frequently.

For example, as the size of the reference value such as the first value, the first rate, the second value, and the second rate decreases, the degradation state of the battery module 11 is more likely to be determined as a complete degradation state rather than an abnormal degradation state.

Then, it is assumed that the weight set for the battery module 11 whose degradation state is determined to be a normal degradation state is the first weight, the weight set for the battery module 11 whose degradation state is determined to be an abnormal degradation state is the second weight, and the weight set for the battery module 11 whose degradation state is determined to be a complete degradation state is the third weight. In this case, the first weight may be greater than the second weight and the third weight, and the second weight may be greater than the third weight. That is, the output of the battery module 11 whose degradation state is determined to be a complete degradation state is less than the output of the battery module 11 whose degradation state is determined to be an abnormal degradation state.

In other words, as the size of the reference value decreases, the output of the battery module 11 is calculated to be smaller, so that degradation of each battery module 11 may be prevented to a greater extent. In other words, the battery power setting apparatus 100 has the advantage of being able to increase the lifespan of the battery pack 10 by reducing the size of the reference value based on the degradation degree of the battery pack 10.

Below, an embodiment in which the control unit 120 determines the power mode of the battery pack 10 is specifically described.

The control unit 120 may be configured to set the power mode of the battery pack 10 to a normal mode, a warning mode, or an emergency mode based on the number or ratio of battery modules 11 determined to be in an abnormal degradation state.

Specifically, the control unit 120 may be configured to determine the power mode based on the number or ratio of battery modules 11 whose degradation state is determined to be an abnormal degradation state or a complete degradation state.

For example, if the degradation states of all battery modules 11 included in the battery pack 10 are normal degradation states, the control unit 120 may set the power mode of the battery pack 10 as a normal mode. In addition, if the degradation state of at least one of the battery modules 11 included in the battery pack 10 is an abnormal degradation state and the degradation states of the remaining battery modules are normal degradation states, the control unit 120 may set the power mode of the battery pack 10 to a warning mode. In addition, if the degradation state of at least one of the battery modules 11 included in the battery pack 10 is a complete degradation state, the control unit 120 may set the power mode of the battery pack 10 to an emergency mode.

As another example, if the ratio of battery module 11, whose degradation state is an abnormal degradation state or a complete degradation state, among the battery modules 11 included in the battery pack 10, is less than a preset third ratio, the control unit 120 may set the power mode of the battery pack 10 to a normal mode. In addition, if the ratio of battery module 11, whose degradation state is an abnormal degradation state or a complete degradation state, among the battery modules 11 included in the battery pack 10, is more than or equal to a third ratio and less than a preset fourth ratio, the control unit 120 may set the power mode of the battery pack 10 to a warning mode. In addition, if the ratio of battery module 11, whose degradation state is an abnormal degradation state or a complete degradation state, among the battery modules 11 included in the battery pack 10, is more than or equal to a fourth ratio, the control unit 120 may set the power mode of the battery pack 10 to an emergency mode.

The battery power setting apparatus 100 has the advantage of being able to specifically distinguish the power mode of the battery pack 10 according to the number or ratio of battery modules 11 whose degradation state is an abnormal state (abnormal degradation state or complete degradation state).

The battery power setting apparatus 100 according to the present disclosure may be applied to a BMS (Battery Management System). That is, the BMS according to the present disclosure may include the battery power setting apparatus 100 described above. In this configuration, at least some of the components of the battery power setting apparatus 100 may be implemented by supplementing or adding functions of the components included in the conventional BMS. For example, the measurement unit 110, the control unit 120 and the storage unit 130 of the battery power setting apparatus 100 may be implemented as components of the BMS.

In addition, the battery power setting apparatus 100 according to the present disclosure may be provided in a battery pack 10. That is, the battery pack 10 according to the present disclosure may include the above-described battery power setting apparatus 100, at least one battery module 11 and at least one battery cell 12. In addition, the battery pack 10 may further include electrical equipment (relays, fuses, etc.) and a case.

FIG. 2 is a schematic drawing of a battery pack 10 according to another embodiment of the present disclosure.

The battery pack 10 may include a plurality of battery modules 11. And, each battery module 11 may include a plurality of battery cells 12.

The measurement unit 110 may be connected to the first sensing line SL1 and the second sensing line SL2. Specifically, the measurement unit 110 may measure the voltage of each of the plurality of battery modules 11 and the plurality of battery cells 12 included in the battery pack 10 through the first sensing line SL1. In the embodiment of FIG. 2, only the first sensing line SL1 is illustrated as a sensing line for voltage measurement, but it should be noted that a plurality of sensing lines can be connected to measure the voltage of each of the battery modules 11 and the battery cells 12.

In addition, the measurement unit 110 may be connected to the current measurement unit A via the second sensing line SL3. For example, the current measurement unit A may be a current meter or a shunt resistor capable of measuring the charging current and discharging current of the battery pack 10.

An external device may be connected to the positive electrode terminal P+ and the negative electrode terminal P- of the battery pack 10. For example, the external device may be a charging device or a load. In addition, the positive electrode terminal P+ of the battery pack 10, the external device, and the negative electrode terminal P- of the battery pack 10 may be electrically connected.

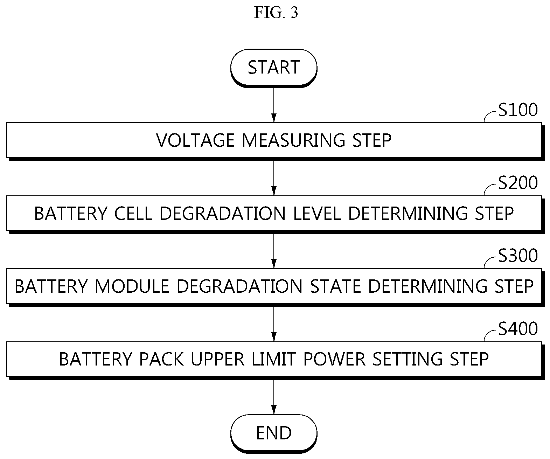

FIG. 3 is a diagram schematically showing a battery power setting method according to still another embodiment of the present disclosure.

Referring to FIG. 3, the battery power setting method may include a voltage measuring step (S100), a battery cell degradation level determining step (S200), a battery module degradation state determining step (S300), and a battery pack upper limit power setting step (S400).

Preferably, each step of the battery power setting method may be performed by the battery power setting apparatus 100. Hereinafter, for convenience of explanation, contents overlapping with the previously described contents will be omitted or briefly described.

The voltage measuring step (S100) is a step of measuring the voltage of each of battery cells 12 under preset conditions, and may be performed by the measurement unit 110.

For example, the measurement unit 110 may be configured to periodically or aperiodically measure the voltage of the battery cell 12, and measure the OCV of the battery cell 12 when the measured voltage satisfies a preset condition. Specifically, the measurement unit 110 may measure the OCV when the voltage of the battery cell 12 reaches a preset voltage and when the battery is in an idle state.

The battery cell degradation level determining step (S200) is a step of determining the degradation level of each battery cell 12 based on the voltage measured by the voltage measuring step (S100), and may be performed by the control unit 120.

Specifically, the control unit 120 may determine the degradation level of the battery cell 12 based on the ratio (voltage change rate) of the voltage fluctuation rate changing between the voltage of battery cell 12 and the preset reference voltage over time (as cycles elapse).

The battery module degradation state determining step (S300) is a step of determining the degradation state of each battery module 11 based on the degradation level of the corresponding battery cell 12, and may be performed by the control unit 120.

The control unit 120 may be configured to determine the degradation state of each battery module 11 based on the number or ratio of battery cells 12 whose degradation level is determined to be accelerated degradation.

First, the control unit 120 may determine the degradation state of the battery module 11 as a normal degradation state or an abnormal degradation state depending on the presence or absence of a battery cell 12 whose degradation level is determined to be accelerated degradation. In addition, the control unit 120 may further determine the degradation state of the battery module 11 whose degradation state is determined to be an abnormal degradation state as an abnormal degradation state or a complete degradation state.

The battery pack upper limit power setting step (S400) is a step of setting the upper limit power of the battery pack 10 by determining the output of each battery module 11 according to the determined degradation state, and may be performed by the control unit 120.

The control unit 120 may be configured to set the power mode of the battery pack 10 to a normal mode, a warning mode, or an emergency mode based on the number or ratio of battery modules 11 determined to be in an abnormal degradation state.

Specifically, the control unit 120 may be configured to determine the power mode based on the number or ratio of battery modules 11 whose degradation state is determined to be an abnormal degradation state or a complete degradation state.

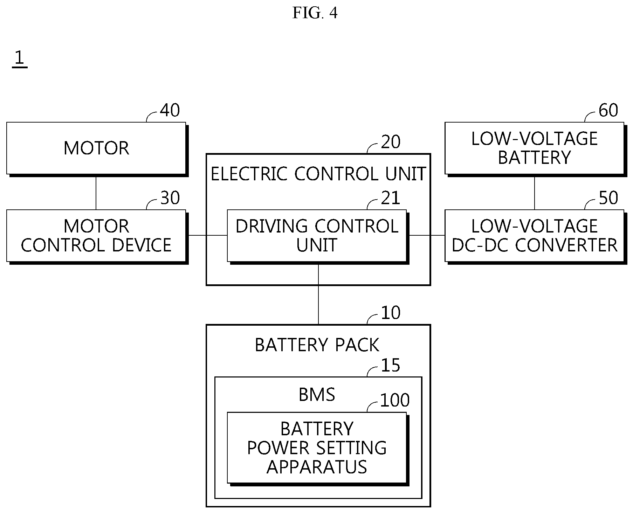

FIG. 4 is a schematic drawing of a vehicle 1 according to yet another embodiment of the present disclosure.

Referring to FIG. 4, the vehicle 1 may include a battery pack 10, an electric control unit (ECU) 20, a motor control unit (MCU) 30, a motor 40, a low-voltage DC-DC converter (LDC) 50, and a low-voltage battery 60.

Here, the battery pack 10 may include one or more battery modules 11 and a BMS (Battery Management System) 15. In addition, the BMS 15 may include the battery power setting apparatus 100. For example, in the embodiment of FIG. 4, the battery power setting apparatus 100 is illustrated as being included in the BMS 15, but the battery power setting apparatus 100 may be implemented by supplementing or adding the functions of the components included in the BMS 15.

Meanwhile, although not shown, the vehicle 1 according to an embodiment of the present disclosure includes a main relay. The main relay is positioned on a predetermined power line connected to the battery pack 10 and controls DC power output through the battery pack 10.

The electric control unit 20 may integrally control power within the vehicle 1. The electric control unit 20 may integrally control power within the vehicle 1, including motor control, regenerative braking control, air conditioning load control, and electrical load power supply control.

The electric control unit 20 includes a driving control unit 21. The driving control unit 21 may transmit a power control signal required to drive the motor 40 to the BMS 15.

The electric control unit 20 may transmit a control signal required for driving the motor 40 to the motor control unit 30. The electric control unit 20 may transmit a pulse width modulation (PWM) control signal required for driving the motor 40 to the motor control unit 30 as the vehicle 1 accelerates or decelerates. The motor control unit 30 may receive power required for driving the motor 40 from the battery pack 10 based on the pulse width modulation control signal received from the electric control unit 20.

The electric control unit 20 may distinguish elements essential for driving the vehicle 1 and other elements and transmit the power control signal required for each element to the BMS 15.

The electric control unit 20 may transmit a low-voltage control signal to the low-voltage DC-DC converter 50 and the BMS 15 to supply power to the low-voltage battery 60. The low-voltage battery 60 may be a device that supplies power to electrical components that operate at low voltage. The low-voltage DC-DC converter 50 may receive power for charging the low-voltage battery 60 from the battery pack 10 based on the low-voltage control signal transmitted from the electric control unit 20.

The motor control unit 30 may control the operation of the motor 40. The motor control unit 30 may include an inverter and an inverter control unit.

The inverter receives DC power from the battery pack 10 according to the switching state of the main relay. In addition, the inverter may convert the DC power supplied from the battery pack 10 into AC power and supply the converted AC power to the motor 40. Here, it is preferable that the AC power converted by the inverter is three-phase AC power.

In particular, the inverter may be formed of an IGBT (Insulated Gate Bipolar Transistor), and the DC power supplied from the battery pack 10 may be converted into AC power as the IGBT is turned on or off according to a pulse width modulation control signal. The converted AC power may drive the motor 40. That is, the motor control unit 30 may control the operation of the motor 40 according to the pulse width modulation control signal received from the electric control unit 20.

The motor control unit 30 may receive power output from the battery pack 10. At this time, the battery pack 10 may supply power based on a power control signal required for driving the motor 40 transmitted from the electric control unit 20 to the BMS 15. The motor control unit 30 may transmit the power output from the battery pack 10 to the motor 40.

The driving control unit 21 may determine the driving condition of the motor 40 and calculate a driving value to drive the motor 40 based on the determined driving condition. The driving control unit 21 may generate a pulse width modulation control signal for controlling the inverter (preferably, for controlling the switching of the IGBT constituting the inverter) based on the calculated driving value.

Accordingly, the inverter may selectively perform an on-off operation according to the pulse width modulation control signal received from the driving control unit 21, thereby converting the DC power supplied from the battery pack 10 into AC power.

The motor 40 may be driven by the AC power supplied from the motor control unit 30. The motor 40 may increase or decrease its driving speed according to the pulse width modulation control signal of the motor control unit 30. That is, the motor 40 may change its rotation speed (revolutions per minute; hereinafter referred to as RPM) according to the control signal of the motor control unit 30. The output of the motor 40 may vary depending on the size of the power supplied from the battery pack 10.

The motor 40 includes a stator (not shown) that is fixed and does not rotate, and a rotor (not shown) that rotates. The motor is supplied with AC power through the inverter.

The motor 40 may be, for example, a three-phase motor, and when a voltage-variable/frequency-variable AC power is applied to the coil of the stator of each phase, the rotation speed of the rotor varies depending on the applied frequency.

The motor 40 may be of various types, such as induction motor, a BLDC motor (blushless DC motor), and a reluctance motor.

Meanwhile, a drive gear (not shown) may be provided at one side of the motor 40. The drive gear converts the rotational energy of the motor 40 into kinetic energy according to a gear ratio. The rotational energy output from the drive gear is transmitted to the front wheels and/or rear wheels to move the electric vehicle 1.

Meanwhile, the vehicle 1 according to the embodiment of the present disclosure may be a concept that includes not only a pure electric vehicle using the battery pack 10 and the motor 40, but also a hybrid electric vehicle that uses an engine along with the battery pack 10 and the motor 40.

In addition, although not shown in the drawings, the vehicle 1 may further include a current measurement unit that detects the magnitude of the current supplied to the motor 40 according to the driving state of the motor 40 as described above.

The current measurement unit detects the three-phase current value (u-phase current value, v-phase current value, w-phase current value) supplied to the motor 40 and transmits it to the driving control unit 21.

The low-voltage DC-DC converter 50 may charge the low-voltage battery 60 by converting the high-voltage DC current output from the battery pack 10 into a low-voltage DC current and supplying the converted high-voltage DC current to the low-voltage battery 60. The motor 40 of the vehicle 1 may directly receive the high-voltage from the battery pack 10 with the high-voltage as its rated voltage, but the electrical components of the vehicle 1 use the low-voltage (e.g., 12 V) as their rated voltage, so it is necessary to step down the high-voltage output from the battery pack 10 to a low-voltage. Accordingly, the low-voltage DC-DC converter 50 may charge the low-voltage battery 60 by converting the high-voltage output from the battery pack 10 into a low-voltage based on the low-voltage control signal transmitted from the electric control unit 20.

The low-voltage battery 60 may be charged by receiving power from the battery pack 10 charged to high voltage. The low-voltage battery 60 may be charged by receiving low-voltage power converted from the high-voltage output from the battery pack 10 through the low-voltage DC converter 50. The low-voltage battery 60 may supply power to electrical components that use low voltage as their rated voltage.

Although not shown, the vehicle 1 may further include a user interface. The user interface may display the power mode of the battery pack 10 set by the BMS 15. Specifically, the power mode of the battery pack 10 is set by the battery power setting apparatus.

The user interface may display the normal mode, the warning mode, and the emergency mode set as the power modes in the BMS 15 by distinguishing them with letters or colors. For example, the user interface may distinguish and display the power mode of the battery pack 10 as one of the normal mode, the warning mode, and the emergency mode by letters on the display panel of the vehicle 1. In addition, the user interface may distinguish and display the power modes by colors with green for the normal mode, yellow for the warning mode, and red for the emergency mode on the display panel of the vehicle 1.

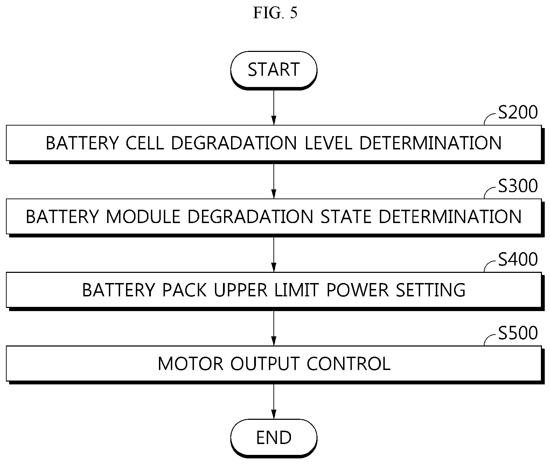

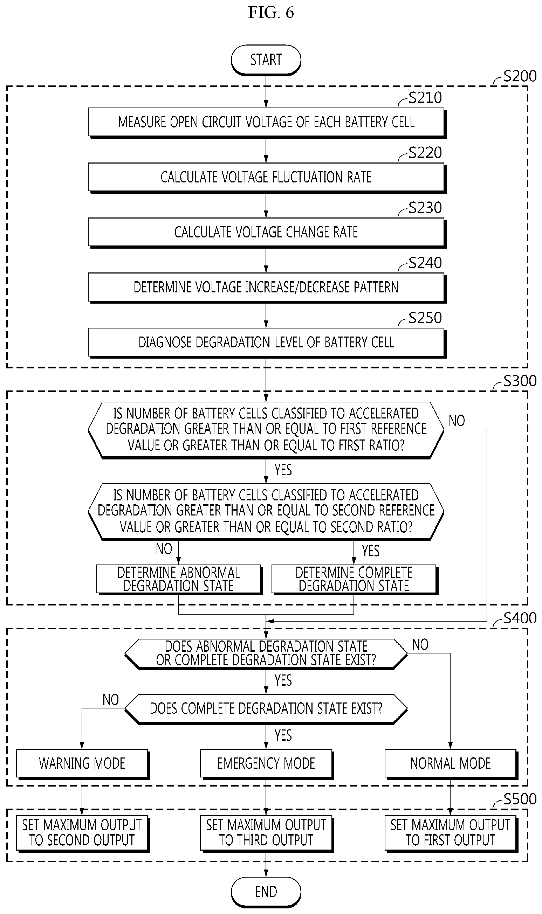

FIG. 5 and FIG. 6 are schematic drawings of a control method of a vehicle 1 according to yet another embodiment of the present disclosure.

Steps S200, S300 and S400 are performed by the control unit 120 of the battery power setting apparatus 100, and are overlapping with the previously described contents, so a detailed description thereof is omitted.

Step S500 is a step for limiting the output of the motor 40, and may be performed by the driving control unit 21 of the electric control unit 20.

The driving control unit 21 may be configured to limit the maximum output of the motor 40 to an output corresponding to the upper limit power.

Specifically, the electric control unit 20 may receive information about the upper limit power of the battery pack 10 from the battery power setting apparatus 100. Preferably, the driving control unit 21 may receive information about the upper limit power of the battery pack 10 from the control unit 120.

In addition, the driving control unit 21 may limit the maximum output of the motor 40 to an output corresponding to the upper limit power of the battery pack 10 or lower in order to delay over-discharge and degradation of the battery pack 10. That is, the driving control unit 21 may limit the maximum output of the motor 40 to correspond to the upper limit power of the battery pack 10.

In the embodiment of FIG. 6, when the power mode of the battery pack 10 is a normal mode, the maximum output may be set to the first output. Then, when the power mode of the battery pack 10 is a warning mode, the maximum output may be set to the second output. Finally, when the power mode of the battery pack 10 is an emergency mode, the maximum output may be set to the third output. Preferably, the first output is greater than the second output and the third output, and the second output is greater than the third output.

For example, even if a driving command exceeding the maximum output of the motor 40 is input to the electric control unit 20 by the driver, the driving control unit 21 may maintain the output of the motor 40 at the set maximum output or below. In addition, the electric control unit 20 may notify the driver through the user interface that the output of the motor 40 is limited to the set maximum output or below.

The vehicle 1 according to an embodiment of the present disclosure may delay degradation of the battery pack 10 by limiting the output of the motor 40 to the output corresponding to the upper limit power of the battery pack 10 or below.

The driving control unit 21 may be configured to further consider the SOH of the battery pack in order to control the output of the motor. That is, in step S500, the driving control unit 21 may compare the SOH (State of health) of the battery pack 10 with the reference SOH and then control the output of the motor 40.

The driving control unit 21 may receive information about the SOH of the battery pack 10 from the BMS 15. Here, the BMS 15 may estimate the SOH of the battery pack 10 by comparing the capacity or internal resistance of the battery pack 10 with the initial value of the battery pack 10. Since various conventional technologies can be employed for the SOH estimation method, a detailed description thereof is omitted.

The driving control unit 21 may temporarily release the limitation on the output of the motor 40 only when the SOH of the battery pack 10 exceeds the reference SOH. That is, even if the power of the battery pack 10 is temporarily over-discharged to exceed the set upper limit power when the SOH of the battery pack 10 exceeds the reference SOH, it may not have a significant effect on the degradation of the battery pack 10. This is because the state of the battery pack 10 is very healthy. Therefore, the driving control unit 21 may temporarily release the limitation on the output of the motor 40 depending on the state of the battery pack 10 in order to improve the output of the motor 40.

Specifically, when an output request exceeding the upper limit power is input, the driving control unit 21 may be configured to limit the maximum output of the motor 40 to correspond to the upper limit power after a time preset to correspond to the power mode of the battery pack 10.

In one embodiment, it is assumed that the SOH of the battery pack 10 exceeds the reference SOH. When the power mode of the battery pack 10 is a normal mode, the driving control unit 21 may set the maximum output to the first output and set the output restriction release time to the first time. Then, when the power mode of the battery pack 10 is a warning mode, the driving control unit 21 may set the maximum output to the second output and set the output restriction release time to the second time. Finally, when the power mode of the battery pack 10 is an emergency mode, the driving control unit 21 may set the maximum output to the third output and set the output restriction release time to the third time. Preferably, the first time is greater than the second time and the third time, and the second time is greater than the third time. More preferably, the third time is set to 0, so that the output restriction of the battery pack 10 in the emergency mode is not released.

For example, assume that the SOH of the battery pack 10 exceeds the reference SOH and the power mode of the battery pack 10 is determined to be a normal mode. If a driving command exceeding the maximum output of the motor 40 is input to the electric control unit 20 by the driver, the driving control unit 21 may maintain the output of the motor 40 as the output corresponding to the driving command only for the first time, and thereafter limit the output of the motor 40 to the output corresponding to the upper limit power of the battery pack 10.

In another embodiment, it is assumed that the SOH of the battery pack 10 is lower than the reference SOH. In this case, even if the power mode of the battery pack 10 is determined to be a normal mode, the restriction on the output of the motor 40 may not be released.

The vehicle 1 according to an embodiment of the present disclosure has the advantage of increasing driver satisfaction by dynamically releasing the restriction on the output of the motor 40 based on the SOH of the battery pack 10.

Below, another embodiment is described in which the driving control unit 21 controls the driving of the motor 40.

The driving control unit 21 may be configured to obtain weather information.

For example, the vehicle 1 may measure weather-related factors such as temperature and humidity outside the vehicle 1 through the equipped sensors. In addition, the electric control unit 20 may generate weather information outside the vehicle 1 based on the weather-related factors measured through the sensors.

As another example, the vehicle 1 may further include a weather information obtaining unit (not shown). The weather information obtaining unit may measure weather-related factors such as temperature and humidity outside the vehicle 1 through the sensors to generate weather information outside the vehicle 1. The weather information obtaining unit may transmit the generated weather information to the driving control unit 21.

For convenience of explanation, the following description assumes that weather information includes information on temperature and humidity. However, it should be noted that weather information may include any weather-related factor that may affect the degradation of the battery pack 10, and may also include single information such as temperature or humidity.

The driving control unit 21 may be configured to determine a weight corresponding to the weather information obtained from a preset table.

Specifically, the table is a table in which weights corresponding to weather-related elements are preset. For example, weights according to temperature and humidity may be preset in the table. For a more specific example, when the temperature is t°C and the humidity is h%, the corresponding weight may be preset. The driving control unit 21 may determine the weight corresponding to the weather information by inputting the acquired weather information into the table. Here, the weight may be within a range of 0 or more and 1 or less.

If the acquired weather information is at a level that does not affect the degradation of the battery pack 10, the weight may be determined as 1. Conversely, if the acquired weather information is at a level that affects the degradation of the battery pack 10 (e.g., high temperature and humidity), the weight may be determined in a range of 0 or more and less than 1.

The driving control unit 21 may be configured to add the determined weight to the output corresponding to the upper limit power.

Specifically, the driving control unit 21 may calculate an output corresponding to the upper limit power of the battery pack 10 and add the determined weight to the calculated output. For example, the driving control unit 21 may reduce the calculated output by multiplying the calculated output by the weight.

The driving control unit 21 may be configured to limit the output of the motor 40 to the weighted output or less.

The driving control unit 21 may primarily limit the output of the motor 40 to an output corresponding to the upper limit power of the battery pack 10, and secondarily limit the output of the motor 40 to an output to which a weight considering the weather information is added. Therefore, even if the vehicle 1 is in operation, the motor 40 is driven within a limited output range, so degradation of the battery pack 10 may progress slowly.

In general, the degradation rate of the battery pack 10 may be affected by temperature, humidity, etc. For example, the battery pack 10 exposed to a high temperature and high humidity environment is prone to internal overheating, which may cause the chemical reaction speed inside the battery cell to increase, resulting in rapid heat generation, and thus unstable heat accumulation.

In addition, as the battery pack 10 is exposed to a high temperature environment, the amount of internal gas generated in the battery cell 12 may increase. In this case, the swelling phenomenon in which the battery cell 12 swells may occur due to the increased internal gas, and there is a problem in that the internal gas may be emitted from the battery cell 12 as the battery cell 12 is vented.

Therefore, the battery pack 10 exposed to such an environment may degrade more rapidly than the battery pack 10 that is not exposed to such an environment. Therefore, the vehicle 1 according to an embodiment of the present disclosure may more effectively prevent the battery pack 10 from degrading by further limiting the output of the motor 40 using a weight based on the weather information.

Below, another embodiment is described in which the driving control unit 21 controls the driving of the motor 40.

The vehicle 1 may further include a navigation unit (not shown). The driver may set a destination by operating the navigation unit. In this case, the navigation unit may calculate a target driving distance by considering the optimal route from the current location of the vehicle 1 to the destination set by the driver. Here, the navigation unit may obtain real-time road traffic information from an external source via a wired and/or wireless network, and determine the optimal route to the destination by considering the obtained real-time road traffic information.

The driving control unit 21 may be configured to obtain information about the target driving distance to the destination, the capacity of the battery pack 10, and the driving pattern of the vehicle 1.

Here, the target driving distance is a distance corresponding to the optimal path to the destination calculated by the navigation unit, and the driving control unit 21 may receive the target driving distance from the navigation unit. The capacity of the battery pack 10 is information about the SOC of the battery pack 10, and the driving control unit 21 may receive information about the capacity of the battery pack 10 from the control unit 120. The driving pattern is information about the fuel economy ([km/kWh]) of the vehicle 1, and may be stored in advance in a memory unit (not shown) of the electric control unit 20.

The driving control unit 21 may be configured to control the driving of the motor 40 based on the upper limit power, the capacity of the battery pack 10, the target driving distance, and the driving pattern.

First, the driving control unit 21 may be configured to calculate a first output value corresponding to the upper limit power. Specifically, the driving control unit 21 may calculate the first output value by converting the upper limit power of the battery pack 10 set by the control unit 120 into the output value of the motor 40.

The driving control unit 21 may be configured to calculate a second output value for driving the target driving distance based on the capacity of the battery pack 10 and the driving pattern. Specifically, the driving control unit 21 may calculate a second output value for driving the target driving distance of the vehicle 1 using the SOC of the battery pack 10, considering the fuel economy of the vehicle 1. For example, the control unit 120 may calculate, as the second output value, the maximum value among the output values of the motor 40 that the vehicle 1 may output to reach the destination within the SOC of the battery pack 10, considering the fuel economy of the vehicle 1.

The driving control unit 21 may be configured to limit the output of the motor 40 to a smaller value of the first output value and the second output value or less.

Specifically, the driving control unit 21 may select a lower output value between the first output value and the second output value. In addition, the driving control unit 21 may control the output of the motor 40 to the selected output value or less.

That is, if the output of the motor 40 is limited to the first output value calculated by considering only the upper limit power of the battery pack 10, the capacity of the battery pack 10 may decrease more rapidly than expected, making it impossible to drive to the destination. Therefore, the vehicle 1 according to an embodiment of the present disclosure has an advantage in that, when a destination is set, the output of the motor 40 may be further limited so that the vehicle 1 may reach the destination by controlling the operation of the motor 40 based on the result of comparing the first output value and the second output value.

The driving control unit 21 may be configured to calculate a second output value that causes the capacity of the battery pack 10 to be greater than or equal to a preset threshold capacity when the target driving distance is reached, taking into account the driving pattern.

Specifically, the battery pack 10 may degrade more slowly when it maintains an appropriate range of SOC than when it is fully charged and fully discharged. For example, maintaining the SOC of the battery pack 10 in the range of 20% to 80% may delay degradation of the battery pack 10 more than when it is used in the range of 0% to 100% of SOC. Accordingly, the driving control unit 21 may calculate a second output value that causes the capacity of the battery pack 10 to be equal to or greater than a preset threshold capacity (e.g., SOC 20% or a corresponding capacity) even when the target driving distance is reached.

That is, the driving control unit 21 may slow down the degradation of the battery pack 10 by preventing the capacity of the battery pack 10 from falling below the threshold capacity during the driving process to the destination. Therefore, the expected lifespan of the battery pack 10 may be increased through the driving control of the motor 40.

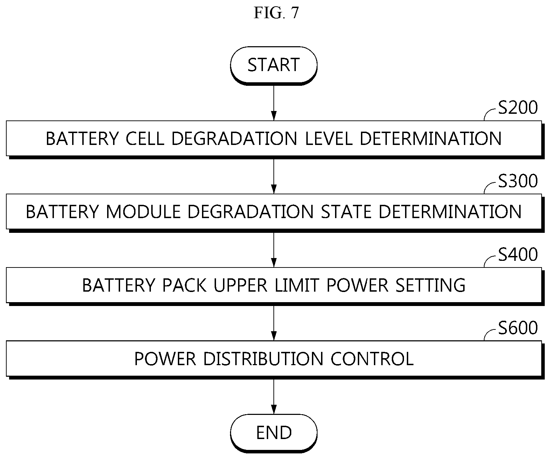

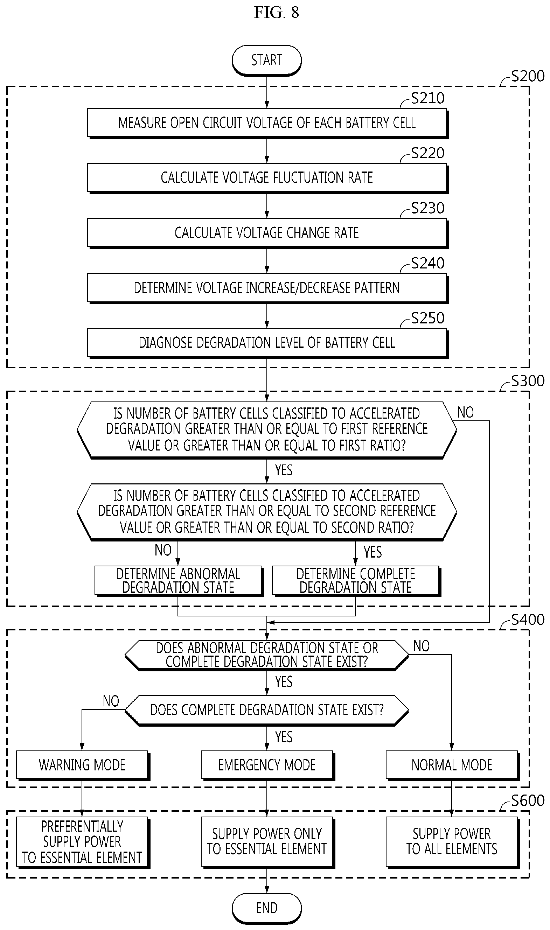

Hereinafter, with reference to FIGS. 7 and 8, another embodiment is described in which the driving control unit 21 controls power distribution to essential elements and auxiliary elements based on the upper limit power of the battery pack 10.

Devices essential to vehicle operation are described as essential elements. For example, the essential elements may include devices directly related to the operation and driving of a vehicle, such as a motor, a reducer, and an inverter.

And, among the devices included in the vehicle, the remaining devices excluding the essential elements are described as auxiliary elements. For example, the auxiliary elements may include devices that are not essential for driving the vehicle but assist in driving or are related to driver convenience, such as an air conditioning device, an audio device, and a display device.

However, please note that the above-described essential elements and auxiliary elements are only examples and are not limited by the present disclosure.

FIG. 7 and FIG. 8 are schematic drawings of a vehicle control method according to yet another embodiment of the present disclosure.

Steps S200, S300 and S400 are performed by the control unit 120 of the battery power setting apparatus 100, and are overlapping with the previously described contents, so a detailed description thereof is omitted.

Step S600 is a step for controlling the distribution of power of the battery pack, and may be performed by the driving control unit 21 of the electric control unit 20.

The driving control unit 21 may be configured to control power distribution to essential elements and auxiliary elements of the vehicle 1 based on the upper limit power of the battery pack 10.

Specifically, the electric control unit 20 may receive information about the upper limit power of the battery pack 10 from the battery power setting apparatus 100. Preferably, the driving control unit 21 may receive information about the upper limit power of the battery pack 10 from the control unit 120.

In addition, the driving control unit 21 may distribute power to the essential element and auxiliary element within the upper limit power of the battery pack 10 to delay over-discharge and degradation of the battery pack 10.

Preferably, the driving control unit 21 may be configured to control the output of the battery pack 10 so that power is supplied to the essential element first within the range of the upper limit power, and power is supplied to the auxiliary element within the range of the remaining power. That is, the driving control unit 21 may set the priority of the essential element to be higher than the priority of the auxiliary element, and control the output of the battery pack 10 so that power is supplied first to the essential element with the higher priority.

More preferably, the driving control unit 21 may set priorities among the devices included in the essential element and may also set priorities among the devices included in the auxiliary element. In addition, the driving control unit 21 may control the output of the battery pack 10 so that power is input starting from the devices with the highest priority.

If it is expected that at least one of the essential elements will not be supplied with the minimum required power (the minimum power required to operate the device), the driving control unit 21 may control the output of the battery pack 10 so that power greater than or equal to the minimum required power is supplied to all devices included in the essential element. In this case, since power is supplied to all the essential elements, the vehicle 1 may be operated.

For example, if the recommended required power (the recommended power required to drive the corresponding device) is supplied by considering the priorities of the devices included in the essential element, there may be cases where the minimum required power cannot be supplied to at least one of the essential elements. In this case, since driving of the vehicle 1 itself is impossible, the driving control unit 21 may control the output of the battery pack 10 so that power corresponding to the minimum required power is supplied to all devices included in the essential element within the upper limit power of the battery pack 10.

If power corresponding to the minimum required power cannot be supplied to all devices included in the essential element even within the upper limit power of the battery pack 10, the driving control unit 21 may temporarily release the restriction on the upper limit power of the battery pack 10 so that power corresponding to the minimum required power can be supplied to all devices included in the essential element. In addition, the driving control unit 21 may notify the driver through the user interface that the restriction on the upper limit power of the battery pack 10 has been temporarily released.

The vehicle 1 according to the present disclosure has the advantage of being able to preferentially provide the power required for the driving vehicle 1 by appropriately distributing power to essential elements and auxiliary elements within the upper limit power of the battery pack 10.

Referring to FIG. 8, the driving control unit 21 may be configured to control power distribution to the essential element and the auxiliary element based on the power mode of the battery pack 10. Here, the power mode of the battery pack 10 is set by the control unit 120 and may be set to a normal mode, a warning mode, or an emergency mode.

The driving control unit 21 may distinguish between elements to supply power and elements to cut off power supply based on the power mode of the battery pack 10.

When the power mode of the battery pack 10 is a normal mode, the driving control unit 21 may control the output of the battery pack 10 so that power is supplied to all elements (essential elements and auxiliary elements) of the vehicle 1.

For example, the driving control unit 21 may control the output of the battery pack 10 so that the recommended power required by each device of all elements is supplied to the corresponding device.

When the power mode of the battery pack 10 is a warning mode, the driving control unit 21 may control the output of the battery pack 10 so that power is preferentially supplied to the essential element and lower power is supplied to the auxiliary element than the case where the power mode of the battery pack 10 is a normal mode.

For example, the driving control unit 21 may control the output of the battery pack 10 so that the recommended required power required by each device of the essential element is supplied to the corresponding device. In addition, the driving control unit 21 may control the output of the battery pack 10 so that the power that is equal to or greater than the minimum required power required by each device of the auxiliary element and less than the recommended required power is supplied to the corresponding device.

When the power mode of the battery pack 10 is an emergency mode, the driving control unit 21 may control the output of the battery pack 10 so that power is supplied only to the essential elements, and power is not supplied to the auxiliary elements or the minimum required power required by each device is supplied to the auxiliary elements.

For example, the driving control unit 21 may control the output of the battery pack 10 so that power that is equal to or greater than the minimum required power required by each device of the essential element and equal to or less than the recommended required power is supplied to the corresponding device. In addition, the driving control unit 21 may limit the output of the battery pack 10 so that power is not supplied to each device of the auxiliary element.

As another example, when power is supplied to each device of the essential element and power of the battery pack 10 remains, the driving control unit 21 may control the output of the battery pack 10 so that the minimum required power required by each device of the auxiliary element is supplied within the remaining power range of the battery pack 10.

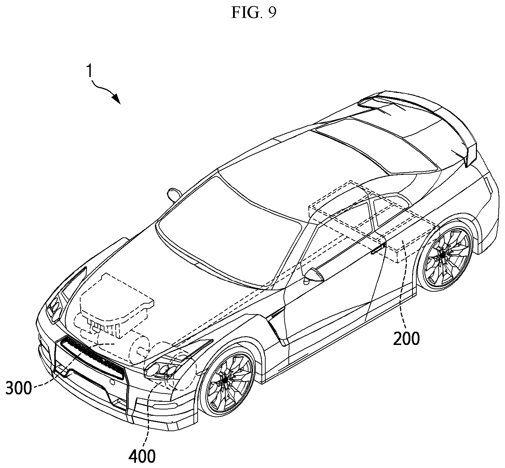

Hereinafter, with reference to FIGS. 9 to 45, a vehicle according to still another embodiment of the present disclosure will be specifically described.

FIG. 9 is a perspective view of a hybrid electric vehicle according to one embodiment.

Referring to FIG. 9, the hybrid electric vehicle 1 may include a first battery 200, an engine 300, and a motor 400 connected to the first battery 200.

The first battery 200 may correspond to the battery pack 10 described above. The motor 400 may correspond to the motor 40 described above.

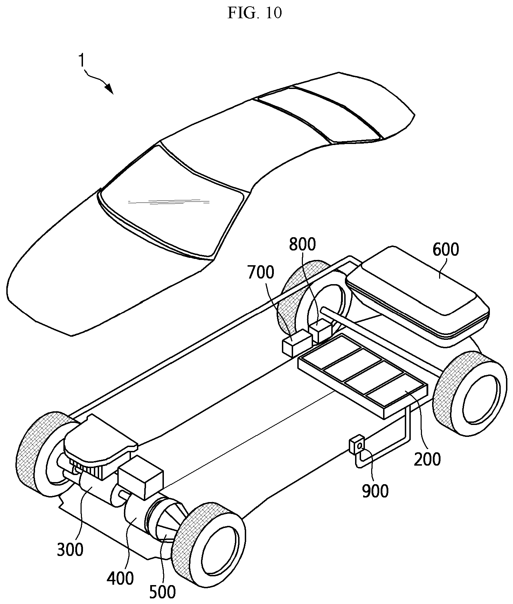

The first battery 200 may supply charged electric energy to the motor 400. The motor 400 may convert the electric energy supplied from the first battery 200 into kinetic energy to provide power to the hybrid electric vehicle 1. The engine 300 is arranged to be spaced apart from the motor 400 and may provide power to the hybrid electric vehicle 1 based on fuel supplied from a fuel tank (see 600 in FIG. 10). That is, the vehicle 1 according to FIG. 9 may be a hybrid electric vehicle driven by the motor 400 and/or the engine 300. In FIG. 9, the engine 300 and the motor 400 are exemplified as providing power only to two wheels (front wheels) located in the front portion FP of the hybrid electric vehicle 1. However, this is not limited thereto, and the engine 300 and the motor 400 may provide power only to two wheels (rear wheels) located in the rear portion RP of the hybrid electric vehicle 1, or may provide power to both the front and rear wheels. In the following, for convenience of explanation, the explanation will be centered on the case where the engine 300 and the motor 400 are located in the front portion FP and provide power to the front wheels.

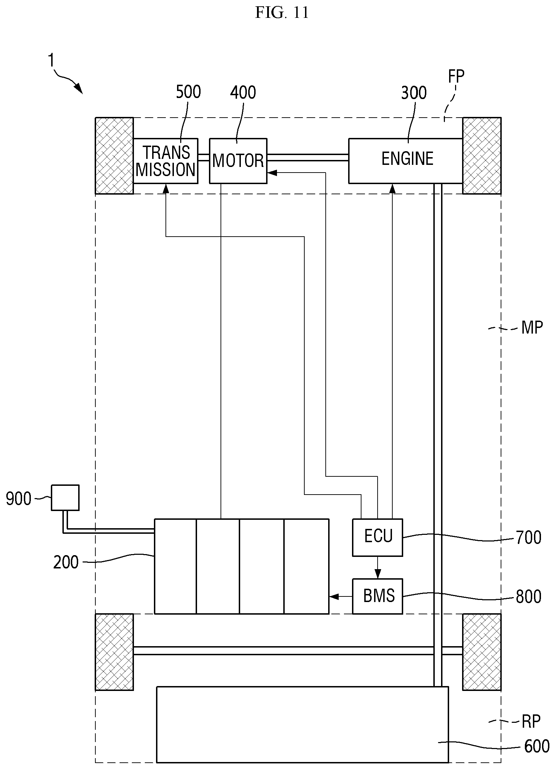

FIG. 10 is an exploded perspective view of the hybrid electric vehicle according to FIG. 9. FIG. 11 is a drawing showing in detail the configuration of the hybrid electric vehicle according to FIG. 10.

Referring to FIGS. 10 and 11, the hybrid electric vehicle 1 may include a first battery 200, an engine (ENGINE, 300), a motor (MOTOR, 400), a transmission (TRANSMISSION, 500), a fuel tank 600, an electric control unit (ECU, 700), a battery management system (BMS, 800), and a plug-in charger 900.

The battery management system 800 according to the present disclosure may correspond to the BMS 15 described above. That is, the battery power setting apparatus 100 may be applied to the battery management system 800. For example, the measurement unit 110, the control unit 120, and the storage unit 130 of the battery power setting apparatus 100 may be implemented as components of the battery management system 800.

The first battery 200 may be charged via the plug-in charger 900. The first battery 200 may be a plug-in type battery. The plug-in charger 900 may receive electrical energy from an external electrical charging device and supply the electrical energy to the first battery 200 to charge the first battery 200. The first battery 200 may be connected to the motor 400.

The engine 300 may provide power to the hybrid electric vehicle 1 based on the fuel supplied from the fuel tank 600. The motor 400 may provide power to the hybrid electric vehicle 1 by converting electric energy supplied from the first battery 200 into kinetic energy. A clutch may be further arranged between the engine 300 and the motor 400, but is not limited thereto.

The transmission 500 may be positioned between the motor 400 and the wheels, but is not limited thereto. The transmission 500 may shift the power of the motor 400 and/or the power of the engine 300 to move the wheels. A final reduction gear may be further positioned between the transmission 500 and the wheels, but is not limited thereto.

The engine 300, the motor 400, and the transmission 500 may be placed in the front portion FP of the hybrid electric vehicle 1.

The fuel tank 600 may be connected to the engine 300. The fuel tank 600 supplies fuel to the engine 300, and the engine 300 may generate kinetic energy based on the supplied fuel.

The electric control unit 700 may control the engine 300, the motor 400, the transmission 500, and the battery management system 800. The electric control unit 700 may correspond to the electric control unit 20 described above.

The battery management system 800 may control the first battery 200. The battery management system 800 may correspond to the BMS 15 described above.

The battery management system 800 may control the output and charging of the first battery 200. The battery management system 800 is illustrated as being placed separately from the first battery 200, but is not limited thereto, and may be placed within the first battery 200. For convenience of explanation, the following description will focus on the case where the battery management system 800 is placed separately outside the first battery 200.

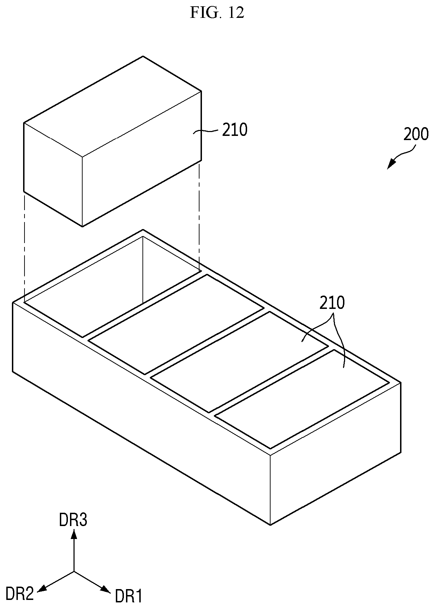

FIG. 12 is a perspective view showing the first battery 200 according to FIG. 11.

Referring to FIG. 12, the first battery 200 may include a plurality of battery modules 210. The battery module 210 may correspond to the battery module 11 described above.

However, the first battery 200 may not be limited thereto. That is, the first battery 200 may be manufactured through a cell-to-pack process without going through the manufacturing step of a battery module 210 including a plurality of battery cells. However, for convenience of explanation, the following description will focus on the first battery 200 including a battery module and battery cells.

Meanwhile, the first battery 200 may further include other components other than the battery cell, for example known components of the first battery 200, such as a BMS, a bus bar, a pack case, a relay, and a current sensor.

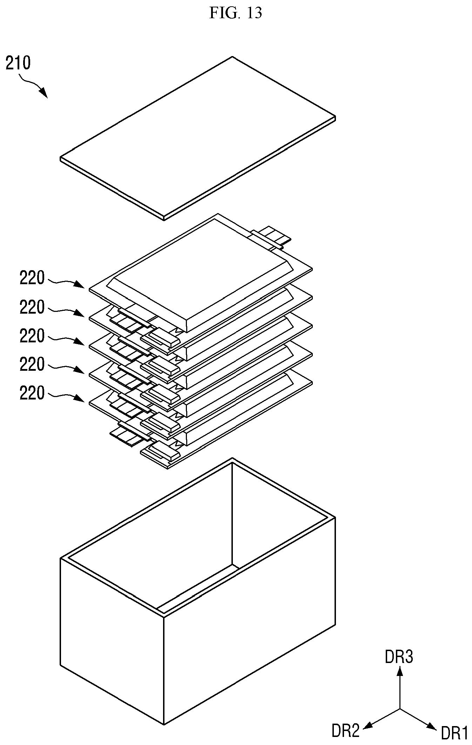

FIG. 13 is a perspective view showing the battery module 210 of the first battery 200 of FIG. 12.

Referring to FIG. 13, the battery module 210 may include battery cells 220. The battery module 210 may include, for example, a cell assembly including a plurality of battery cells 220 electrically connected to each other and a module housing that accommodates the cell assembly.

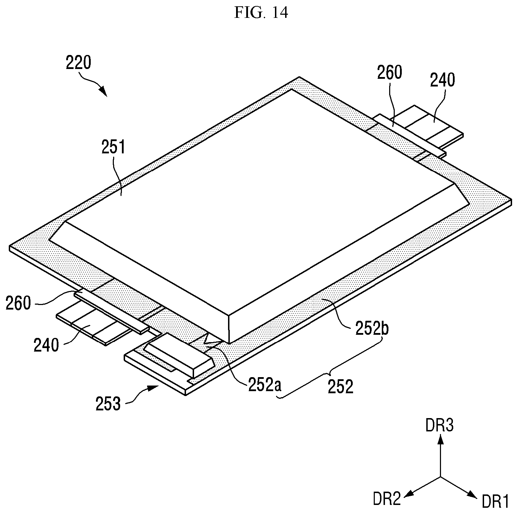

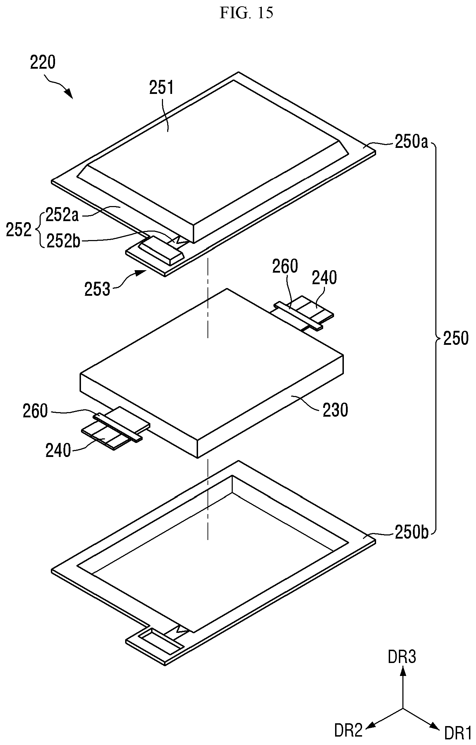

FIG. 14 is a perspective view showing the exterior of the battery cell 220 of FIG. 13. FIG. 15 is an exploded perspective view of the battery cell 220 of FIG. 14.

Referring to FIGS. 14 and 15, the battery cell 220 may include an electrode assembly 230, an electrode lead 240 extending from the electrode assembly 230, and a case 250 that accommodates the electrode assembly 230 such that the electrode lead 240 is pulled outward.

The electrode assembly 230 may include, although not illustrated in detail, a first electrode plate having a first electrode tab, a second electrode plate having a second electrode tab, and a separator interposed between the first electrode plate and the second electrode plate. The first electrode plate may be a positive electrode plate coated with a positive electrode active material or a negative electrode plate coated with a negative electrode active material, and the second electrode plate may correspond to an electrode plate having a polarity opposite to that of the first electrode plate. The first electrode tab may be at least a part of an uncoated portion of the first electrode plate on which the positive electrode active material or the negative electrode active material is not coated. The second electrode tab may be at least a part of an uncoated portion of the second electrode plate on which the positive electrode active material or the negative electrode active material is not coated. This uncoated portion may be a portion protruding from the first electrode plate or the second electrode plate of the electrode assembly 230. Specifically, the electrode tab may be formed by gathering portions processed by a notching process in the uncoated portion. Meanwhile, in the present disclosure, the electrode tab is not limited to being at least a part of the uncoated portion. That is, the electrode tab may be provided separately and coupled to the uncoated portion.

The electrode lead 240 may be extended from the electrode assembly 230. The electrode lead 240 may be coupled to the electrode tab by welding or the like. The electrode lead 240 may be provided as a pair and may be provided on one or both sides of the electrode assembly 230.

The case 250 may accommodate the electrode assembly 230 so that the electrode lead 240 is drawn outward. The case 250 may accommodate an electrolyte inside and accommodate the electrode assembly 230 inside in an impregnated form. The electrode lead 240 may be drawn out from both sides of the case 250, or may be drawn out from only one side. The case 250 may be a pouch film including a metal material layer, but is not limited thereto. The case 250 is formed to accommodate the electrode assembly 230 and prevent the electrolyte from leaking. The case 250 may be formed using a 1-cup method in which a pouch including a first case 250a and a second case 250b connected to each other is folded and a portion where the first case 250a and the second case 250b are in contact is sealed. In contrast, the case 250 may be formed using a 2-cup method in which the first case 250a and the second case 250b are overlapped and sealed as shown in FIG. 15.

The case 250 may include an accommodation portion 251, a sealing portion 252, and a gas discharge pocket 253.

The accommodation portion 251 may accommodate the electrode assembly 230. The accommodation portion 251 may be configured to form an accommodation space that accommodates the electrode assembly 230 approximately near the center of the case 250. Referring to FIG. 15, the first case 250 and the second case 250 may be partially contacted and sealed to form the accommodation portion 251.

The sealing portion 252 may be provided along the edge of the accommodation portion 251. The sealing portion 252 may be formed by sealing the case 250 along the edge of the accommodation portion 251 by high temperature compression. In the case of a 1-cup method in which one pouch is folded and sealed, the sealing portion 252 may be formed on three sides excluding the folded portion of the pouch. In the case of a 2-cup method in which the first case 250a and the second case 250b are overlapped and sealed as illustrated in FIG. 15, the sealing portion 252 may be formed on four sides. The sealing portion 252 may have a weak sealing portion 252a configured to have a lower sealing strength than the other region 252b. The other region 252b may be the remainder of the sealing portion 252 excluding the weak sealing portion 252a.

The gas discharge pocket 253 may be provided at a position corresponding to the weak sealing portion 252a. The gas discharge pocket 253 may be configured to be in communication with the accommodation portion 251 when the weak sealing portion 252a is ruptured due to an increase in internal pressure caused by gas generation inside the battery cell 220.

Although not shown in the drawing, the gas discharge pocket 253 and the weak sealing portion 252a may be provided in a desired number at a desired location depending on the location and time at which gas discharge is desired to occur.

The battery cell 220 may include a sealing tape 260. The sealing tape 260 may be interposed between the electrode lead 240 and the inner surface of the case 250. The sealing tape 260 may include a heat-sealable film to enhance the sealing performance of the case 250 in the area where the electrode lead 240 is drawn out. The sealing tape 260 may include an insulating material to prevent short-circuiting of the electrode lead 240.

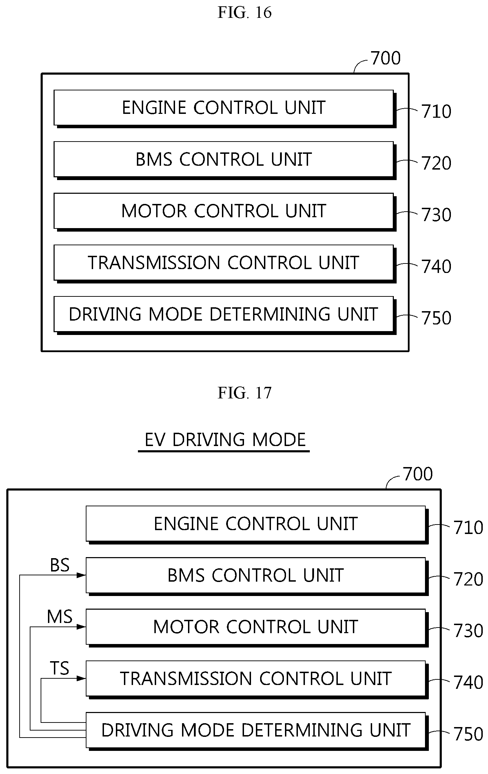

FIG. 16 is a drawing showing the specific configuration of the electric control unit 700 according to FIG. 11.

Referring to FIG. 16, the electric control unit 700 may include an engine control unit 710, a BMS control unit 720, a motor control unit 730, a transmission control unit 740, and a driving mode determining unit 750.

The engine control unit 710 may control the engine 300, the BMS control unit 720 may control the battery management system 800, the motor control unit 730 may control the motor 400, and the transmission control unit 740 may control the transmission 500.

The driving mode determining unit 750 may determine the driving mode of the hybrid electric vehicle 1. For example, the driving mode determining unit 750 may determine whether the hybrid electric vehicle 1 is in an EV (Electric vehicle) driving mode (or EV mode), an HEV (Hybrid electric vehicle) driving mode (or HEV mode), an ENG (Engine) driving mode (or ENG mode), or an RB (Regenerative braking) driving mode (or RB mode).

The specific details of whether it is an EV driving mode, an HEV driving mode, an ENG driving mode, and an RB driving mode, and the functions and operations of the engine control unit 710, the BMS control unit 720, the motor control unit 730, the transmission control unit 740, and the driving mode determining unit 750 in each driving mode will be described in detail with reference to FIGS. 17 to 24.

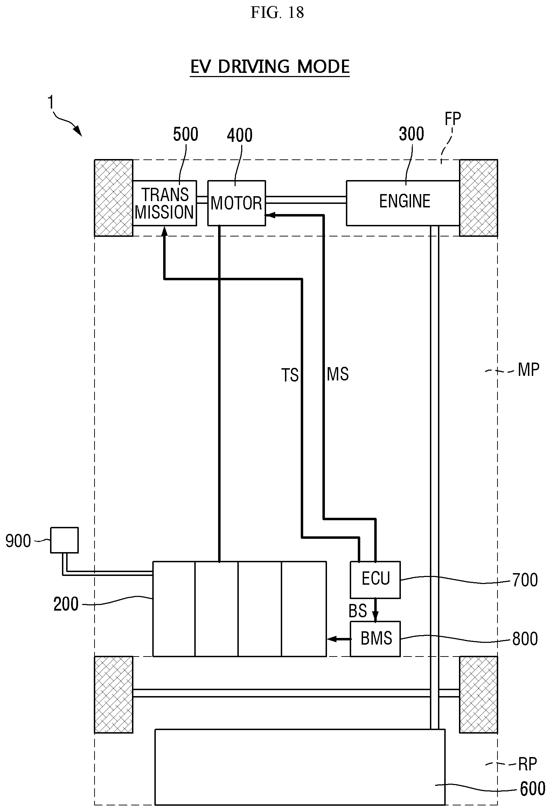

FIG. 17 is a diagram showing the relationships between components of the electric control unit 700 in an EV driving mode. FIG. 18 is a diagram showing the relationships between components of a hybrid electric vehicle in an EV driving mode.

Referring to FIGS. 17 and 18, in the EV driving mode, when the driver steps on the accelerator after starting, the engine clutch is opened and the motor 400 is driven using the power of the first battery 200. The power of the motor 400 moves the wheels through the transmission 500 and the final reduction gear.

Specifically, in the EV driving mode, the driving mode determining unit 750 may determine that the EV driving mode is till the first speed of the hybrid electric vehicle 1 after starting.

The driving mode determining unit 750 may turn on the BMS control unit 720, the motor control unit 730, the transmission control unit 740, and the switch control unit 760.

The driving mode determining unit 750 may generate a battery control signal BS and transmit it to the BMS control unit 720, generate a motor control signal MS and transmit it to the motor 400, generate a transmission control signal TS and transmit it to the transmission 500. In FIG. 17, the driving mode determining unit 750 is exemplified as generating and transmitting the control signals BS, MS, TS to the BMS control unit 720, the motor control unit 730, and the transmission control unit 740, respectively, but is not limited thereto. That is, each of the BMS control unit 720, the motor control unit 730, and the transmission control unit 740 may generate the above-described control signals BS, MS, TS, respectively, under the control of the driving mode determining unit 750. For convenience of explanation, the following description focuses on that the driving mode determining unit 750 generates and transmits the control signals BS, MS, TS to the BMS control unit 720, the motor control unit 730, and the transmission control unit 740, respectively.

The BMS control unit 720 may transmit the generated battery control signal BS to the first battery 200. The first battery 200 may supply power (or electric energy) to the motor 400 based on the battery control signal BS of the BMS control unit 720.

The motor control unit 730 may transmit the generated motor control signal MS to the motor 400. The motor 400 may operate based on the transmitted motor control signal MS.

The transmission control unit 740 may transmit the generated transmission control signal TS to the transmission 500. The transmission 500 may operate based on the transmitted transmission control signal TS.

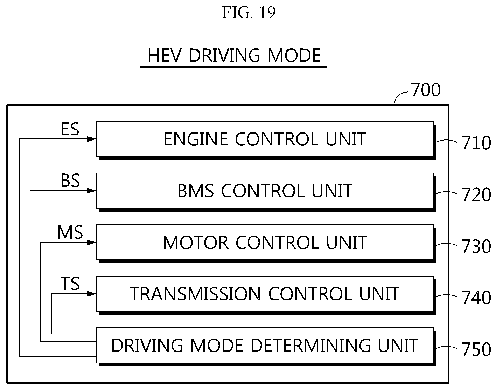

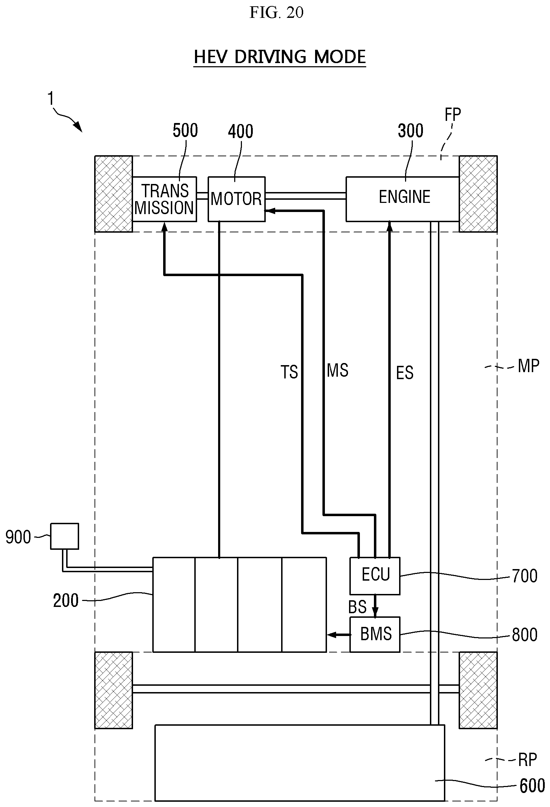

FIG. 19 is a diagram showing the relationships between components of the electric control unit 700 in a HEV driving mode. FIG. 20 is a diagram showing the relationships between components of a hybrid electric vehicle 1 in a HEV driving mode.

Referring to FIGS. 19 and 20, the HEV driving mode may be a driving mode in which the speed of the hybrid electric vehicle 1 is higher than or equal to the first speed. In the HEV driving mode, the engine 300 and the motor 400 drive the hybrid electric vehicle 1 together. In the HEV driving mode, the power of the engine 300 and the motor 400 moves the wheels through the transmission 500 and the final reduction gear.

Specifically, in the HEV driving mode, the driving mode determining unit 750 may determine that the driving mode is HEV driving mode from the first speed or higher.

The driving mode determining unit 750 may turn on the engine control unit 710, the BMS control unit 720, the motor control unit 730, and the transmission control unit 740.

The driving mode determining unit 750 may generate an engine control signal ES and transmit it to the engine control unit 710, generate a battery control signal BS and transmit it to the BMS control unit 720, generate a motor control signal MS and transmit it to the motor 400, and generate a transmission control signal TS and transmit it to the transmission 500. In FIG. 19, the driving mode determining unit 750 is exemplified as generating and transmitting the control signals ES, BS, MS, TS to the engine control unit 710, the BMS control unit 720, the motor control unit 730, and the transmission control unit 740, respectively, but is not limited thereto. That is, each of the engine control unit 710, the BMS control unit 720, the motor control unit 730, and the transmission control unit 740 may generate the above-described control signals MS, BS, MS, TS under the control of the driving mode determining unit 750. For convenience of explanation, the following description will focus on that the driving mode determining unit 750 generates and transmits control signals MS, BS, MS, TS to the engine control unit 710, the BMS control unit 720, the motor control unit 730, and the transmission control unit 740, respectively.

The engine control unit 710 may transmit the generated engine control signal ES to engine 300. The engine 300 may operate based on the transmitted engine control signal ES.

The BMS control unit 720 may transmit the generated battery control signal BS to the first battery 200. The first battery 200 may supply power (or electric energy) to the motor 400 based on the battery control signal BS of the BMS control unit 720.

The motor control unit 730 may transmit the generated motor control signal MS to the motor 400. The motor 400 may operate based on the transmitted motor control signal MS.

The transmission control unit 740 may transmit the generated transmission control signal TS to the transmission 500. The transmission 500 may operate based on the transmitted transmission control signal TS.

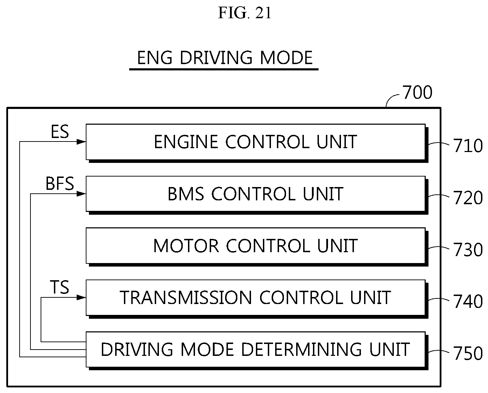

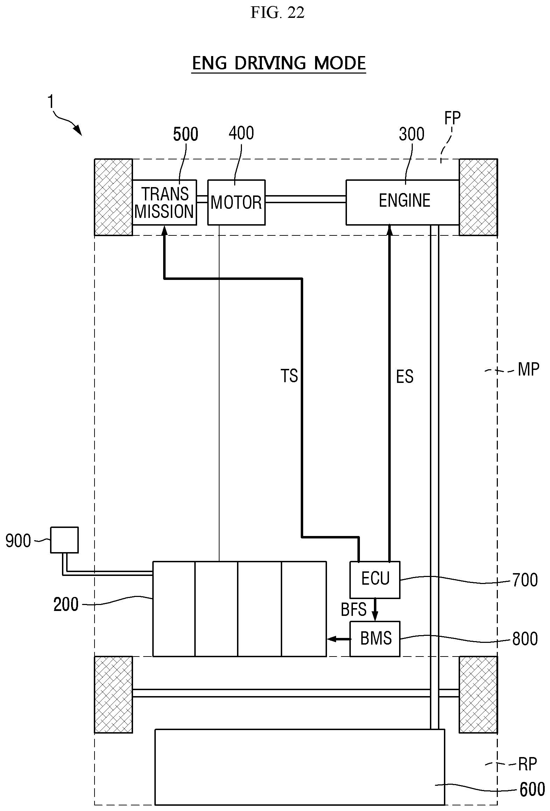

FIG. 21 is a diagram showing the relationships between components of the electric control unit 700 in an ENG driving mode. FIG. 22 is a diagram showing the relationships between components of a hybrid electric vehicle 1 in an ENG driving mode.

Referring to FIGS. 21 and 22, the ENG driving mode may be a driving mode in which the speed of hybrid electric vehicle 1 is higher than or equal to the second speed. In the ENG driving mode, only engine 300 drives the hybrid electric vehicle 1. In the ENG driving mode, the power of the engine 300 moves the wheels through the transmission 500 and the final reduction gear.

Specifically, in the ENG driving mode, the driving mode determining unit 750 may determine that the driving mode is ENG driving mode from the second speed or higher.

The driving mode determining unit 750 may turn on the engine control unit 710 and the transmission control unit 740, and turn off the BMS control unit 720 and the motor control unit 730. In the ENG driving mode, the power supply to the first battery 200 may be cut off by the BMS control unit 720.

The driving mode determining unit 750 may generate an engine control signal ES and transmit it to the engine control unit 710, generate a battery off signal BFS and transmit it to the BMS control unit 720, and generate a transmission control signal TS and transmit it to the transmission 500. In FIG. 21, it is not illustrated that the driving mode determining unit 750 generates a motor off signal for turning off the motor 400 and transmits it to the motor control unit 730, but if the driving mode determining unit 750 does not transmit a motor control signal (see MS of FIG. 19) to the motor control unit 730, the motor 400 may be turned off. However, the present disclosure is not limited thereto, and the driving mode determining unit 750 may separately generate a motor off signal for turning off the motor 400 and transmit it to the motor control unit 730, and the motor 400 may be turned off based on the motor off signal received from the motor control unit 730.

In FIG. 21, it is exemplified that the driving mode determining unit 750 generates and transmits control signals ES, BFS, TS to the engine control unit 710, the BMS control unit 720, and the transmission control unit 740, respectively, but it is not limited thereto. That is, each of the engine control unit 710, the BMS control unit 720, and the transmission control unit 740 may generate the above-described control signals BS, BFS, TS under the control of the driving mode determining unit 750. In the following, for convenience of explanation, the driving mode determining unit 750 will be described with a focus on generating and transmitting control signals ES, BFS, TS to each of the engine control unit 710, the BMS control unit 720, and the transmission control unit 740.

The engine control unit 710 may transmit the generated engine control signal ES to the engine 300. The engine 300 may operate based on the transmitted engine control signal ES.

The BMS control unit 720 may transmit the generated battery off signal BFS to the first battery 200. The first battery 200 may not provide power to the motor 400 based on the battery off signal BFS of the BMS control unit 720.

The transmission control unit 740 may transmit the generated transmission control signal TS to the transmission 500. The transmission 500 may operate based on the transmitted transmission control signal TS.

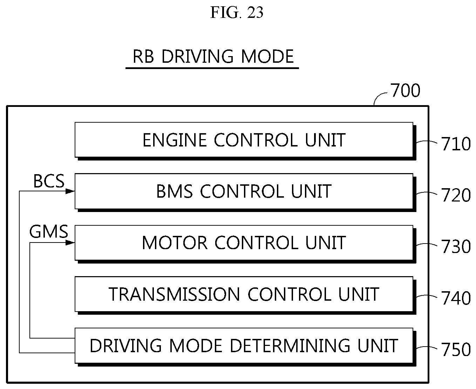

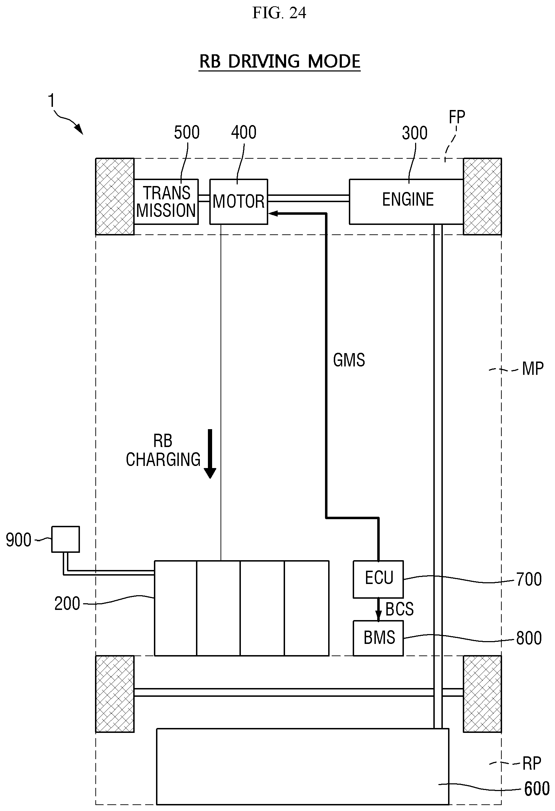

FIG. 23 is a diagram showing the relationships between components of the electric control unit in a RB driving mode. FIG. 24 is a diagram showing the relationship between the components of a hybrid electric vehicle in a RB driving mode.

Referring to FIGS. 23 and 24, the RB driving mode may be a mode that is activated in the braking mode of the hybrid electric vehicle 1.

The RB driving mode may refer to a mode that recovers some of the kinetic energy (or mechanical power) lost in the braking mode and converts it into electrical energy (or electric power).

In the RB driving mode, the motor 400 may operate as a generator instead of converting electrical energy (or electric power) into kinetic energy (or mechanical power). That is, the motor 400 may convert kinetic energy (or mechanical power) into electrical energy (or electric power).

Specifically, in the RB driving mode, the driving mode determining unit 750 may determine that the hybrid electric vehicle 1 is in the RB driving mode when braking.

The driving mode determining unit 750 may turn on the BMS control unit 720, the motor control unit 730, and turn off the transmission control unit 740 and the engine control unit 710.

The driving mode determining unit 750 may generate a battery charging signal BCS and transmit it to the BMS control unit 720, and generate a motor generating signal GMS and transmit it to the motor control unit 730. In FIG. 23, it is not shown that the driving mode determining unit 750 generates a motor off signal for turning off the engine 300 and transmits it to the engine control unit 710, and that the driving mode determining unit 750 generates a transmission off signal for turning off the transmission 500 and transmits it to the transmission control unit 740, but if the driving mode determining unit 750 does not transmit an engine control signal (see ES of FIG. 21) and a transmission control signal (see TS of FIG. 21) to the engine control unit 710 and the transmission control unit 740, respectively, the engine 300 and the transmission 500 may be turned off. However, without being limited thereto, the driving mode determining unit 750 may separately generate an engine off signal and a transmission off signal to turn off the engine 300 and the transmission 500 and transmits them to the engine control unit 710 and the transmission control unit 740, respectively, and the engine 300 and the transmission 500 may be turned off based on the engine off signal and the transmission off signal received from the engine control unit 710 and the transmission control unit 740, respectively.

In FIG. 24, it is exemplified that the driving mode determining unit 750 generates and transmits the control signals BCS, GMS to the BMS control unit 720 and the motor control unit 730, respectively, but it is not limited thereto. That is, each of the BMS control unit 720 and the motor control unit 730 may generate the above-described control signals BCS, GMS, respectively, under the control of the driving mode determining unit 750. In the following, for the convenience of explanation, the explanation will be centered on the fact that the driving mode determining unit 750 generates and transmits the control signals BCS, GMS to the BMS control unit 720 and the motor control unit 730, respectively.

The BMS control unit 720 may transmit the generated battery charging signal BCS to the first battery 200. The first battery 200 may charge (RB CHARGING) the electric energy (or electric power) generated from the motor 400 based on the transmitted battery charging signal BCS.

The motor control unit 730 may transmit the generated motor generating signal GMS to the motor 400. The motor 400 may convert the motor 400 into a generator and operate based on the motor generating signal GMS of the motor control unit 730. The motor 400 may recover some of the kinetic energy (or mechanical power) lost in the RB braking mode and convert it into electric energy (or electric power). The motor 400 may transmit the converted electric energy (or electric power) to the first battery 200.

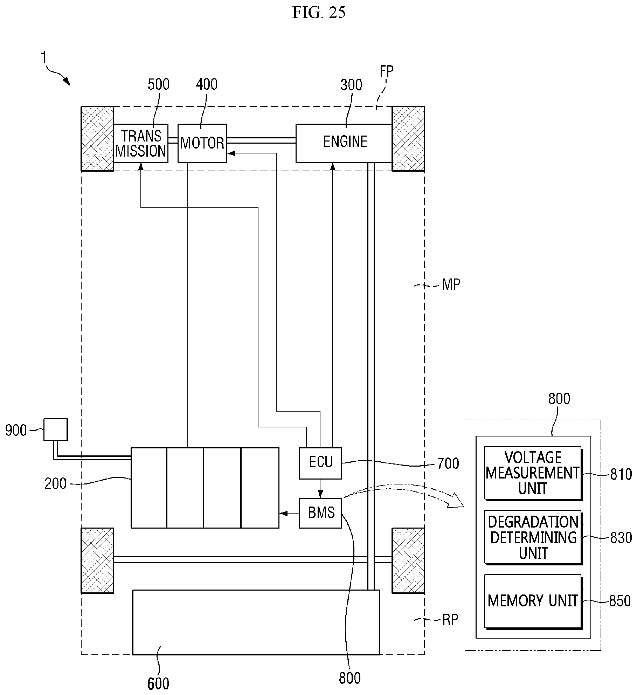

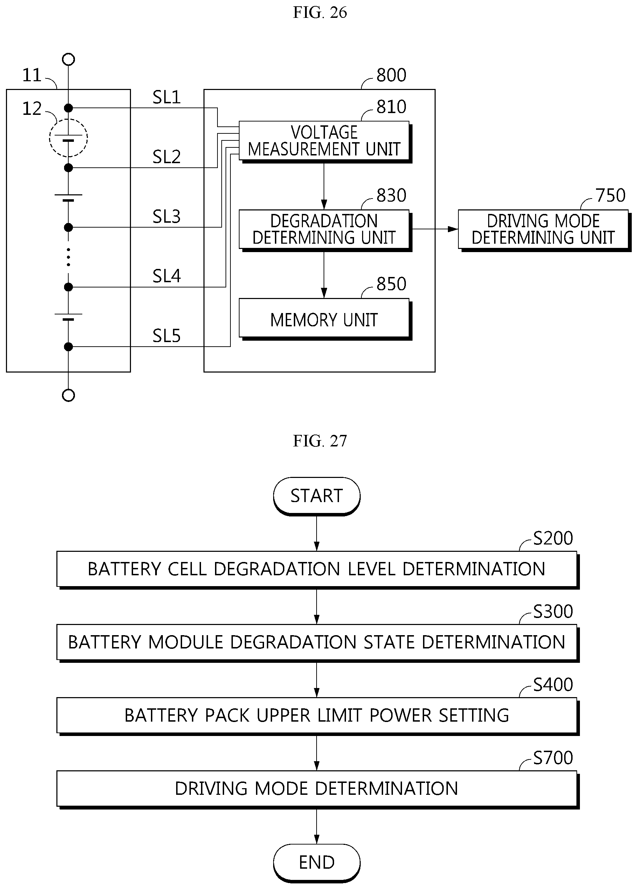

FIG. 25 is a detailed diagram illustrating in detail the configuration of a hybrid electric vehicle 1 according to one embodiment. FIG. 26 is a diagram illustrating the measurement of the open circuit voltage of a battery cell 12 using the battery management system 800 according to FIG. 25. FIG. 27 is a flowchart illustrating a driving mode control method based on the degradation state of the first battery 200 of a hybrid electric vehicle 1 according to one embodiment.

The battery management system 800 may include a voltage measurement unit 810, a degradation determining unit 830, and a memory unit 850.

The voltage measurement unit 810 may measure the voltage when the battery cell 12 included in the battery module 11 is discharged. That is, the voltage measurement unit 810 may be configured to measure the voltage of each battery cell 12 included in the battery module 11. In FIG. 26, for convenience of explanation, the battery management system 800 is illustrated as measuring the voltage of the battery cells 12 included in one battery module 11, but the battery management system 800 may also simultaneously measure the voltages of the battery cells 12 included in a plurality of battery modules 11.

For example, as illustrated in FIG. 26, the voltage measurement unit 810 of the battery management system 800 may measure the voltages of a plurality of battery cells 12 included in the battery module 11, respectively. Specifically, the voltage measurement unit 810 may measure the voltage of the first battery cell 12 through the first sensing line SL1 and the second sensing line SL2, and may measure the voltage of the second battery cell 12 through the second sensing line SL2 and the third sensing line SL3. In addition, the voltage measurement unit 810 may measure the voltage of the third battery cell 12 through the third sensing line SL3 and the fourth sensing line (not shown), and may measure the voltage of the n-th battery cell 12 through the n-1-th sensing line (SLn-1) and the n-th sensing line (SLn).

The voltage measurement unit 810 may measure the open circuit voltage (OCV) of the battery cell 12. That is, the voltage measurement unit 810 may measure both the voltage and the open circuit voltage of the battery cell 12. In particular, the voltage measurement unit 810 may measure the open circuit voltage of each battery cell 12 when the measured voltage reaches a preset voltage and after a certain time has elapsed. For example, the voltage measurement unit 810 may measure the open circuit voltage of each battery cell 12 when the measured voltage reaches a preset voltage and after a certain time has elapsed so that each battery cell 12 reaches an idle state.

Here, the preset voltage is commonly applied to the battery cell 12 and is a voltage value preset to unify the OCV measurement time point. For example, the preset voltage may be set to the discharge end voltage or charge end voltage of a plurality of battery cells 12. As another example, the preset voltage may be preset to a specific voltage included in the voltage range (e.g., 2.8 [V] to 4.2 [V]) of the battery cell 12.

For example, it is assumed that the preset voltage is set to V1 [V] for each of battery cells 12. At this time, the voltage measurement unit 810 may measure the open circuit voltage of the first battery cell 12 when the voltage of the first battery cell 12 reaches V1. Similarly, the voltage measurement unit 810 may measure the open circuit voltage of the second battery cell 12, the third battery cell 12, the fourth battery cell 12, or the nth battery cell 12 when the voltage of the second battery cell 12, the third battery cell 12, the fourth battery cell 12, or the nth battery cell 12 reaches V1.

The degradation determining unit 830 may classify the degradation level for each battery cell 12 based on the voltage magnitude and change rate measured during the charging and discharging process. A plurality of battery cells 12 may be classified into one of decelerated degradation, linear degradation, and accelerated degradation for each cell by the degradation determining unit 830.

The battery module 11 may be determined to be in an abnormal degradation state, a normal state, or a complete degradation state by the degradation determining unit 830, depending on the number of battery cells 12 classified as accelerated degradation among the plurality of battery cells 12 included in each battery module. Alternatively, the battery module 11 may be determined to be in an abnormal degradation state, a normal state, or a complete degradation state by the degradation determining unit 830, depending on the ratio of battery cells 12 classified as accelerated degradation among the plurality of battery cells 12 included in each battery module.

The memory unit 850 stores data regarding the preset voltage, and when the degradation determining unit 830 determines the degradation level of the battery cell 12, the data regarding the preset voltage may be transmitted to the degradation determining unit 830.

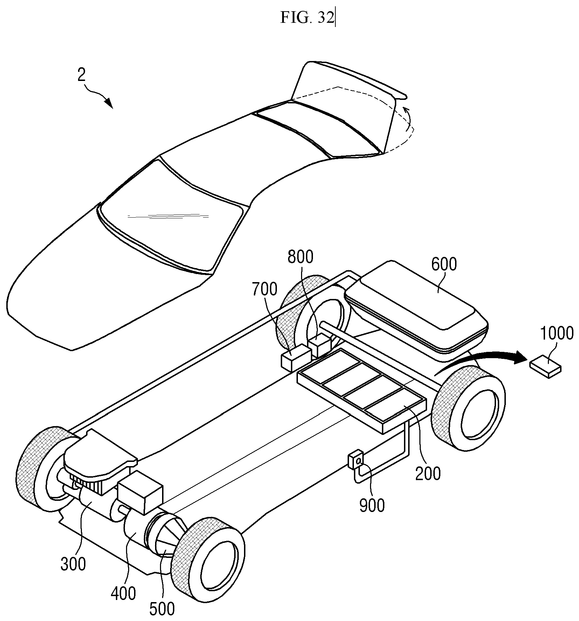

Hereinafter, a driving mode determination method based on the degradation state of the first battery 200 of a hybrid electric vehicle 1 will be described in detail with reference to FIGS. 27 to 31. It is obvious that the contents described with reference to FIGS. 27 to 31 may also be applied to the battery management system 800 of the hybrid electric vehicle according to FIGS. 32 to 45, which will be described later.

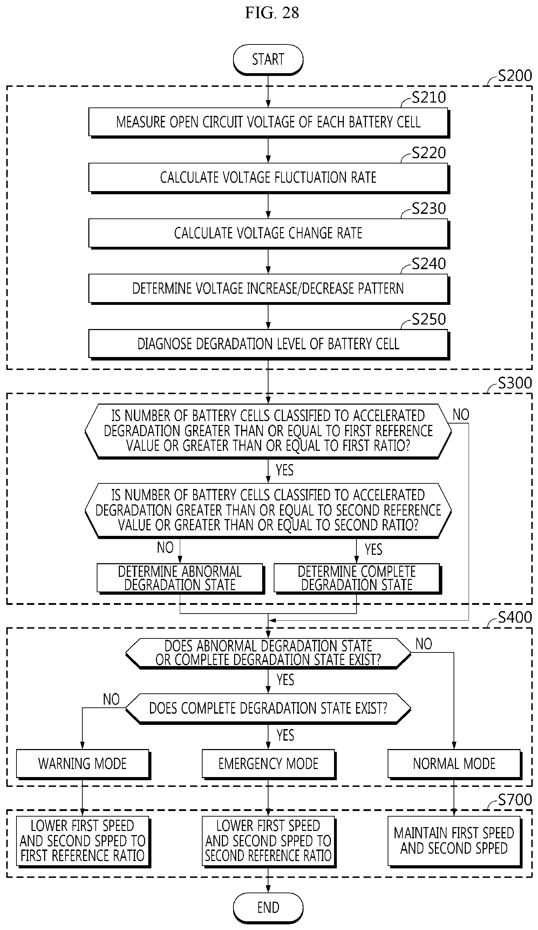

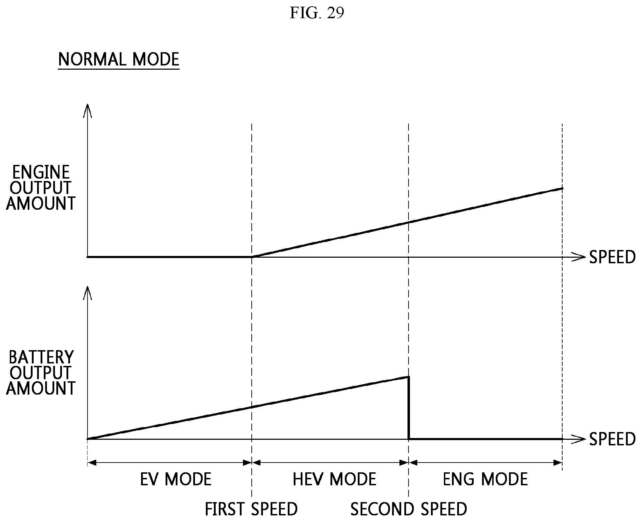

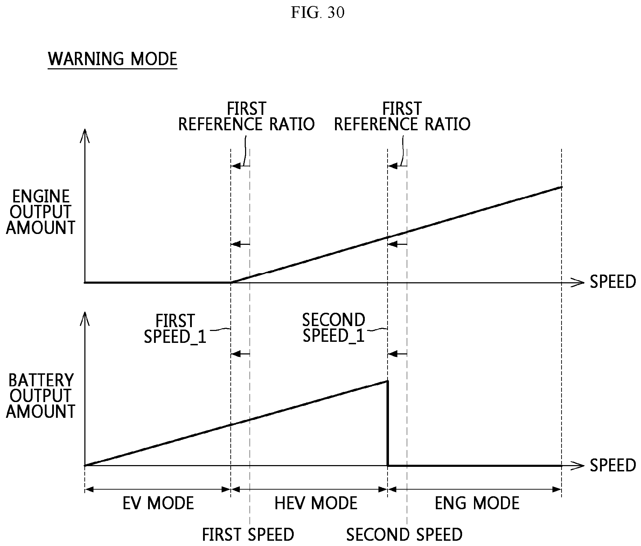

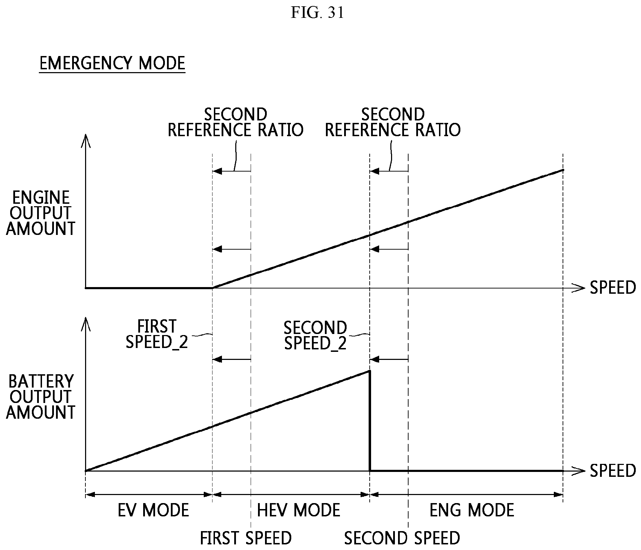

FIG. 28 is a flowchart illustrating more detailed steps of FIG. 27. FIG. 29 is a graph illustrating driving mode control in a normal mode of FIG. 28. FIG. 30 is a graph illustrating driving mode control in a warning mode of FIG. 28. FIG. 31 is a graph illustrating driving mode control in an emergency mode of FIG. 28.

Referring to FIG. 27, the method for determining a driving mode based on the degradation state of the first battery 200 of the hybrid electric vehicle 1 using the battery management system 800 may include a battery cell degradation level determining step (S200), a battery module degradation state determining step (S300), a battery pack upper limit power setting step (S400), and a driving mode determining step (S700).

The battery cell degradation level determining step (S200), the battery module degradation state determining step (S300), and the battery pack upper limit power setting step (S400) are described in more detail. Note that the battery cell degradation level determining step (S200), the battery module degradation state determining step (S300), and the battery pack upper limit power setting step (S400) described below may also be applied to the previously described embodiment.

In the battery cell degradation level determining step (S200), the battery management system 800 may diagnose the degradation level of a plurality of battery cells 12.

Specifically, the battery management system 800 may classify the degradation level of each of the battery cells 12. Specifically, the battery management system 800 can measure the voltage of each of the battery cells 12 when charging the battery and classify the degradation level of each of the battery cells 12 as one of decelerated degradation, linear degradation, and accelerated degradation.

Here, the normal degradation, the linear degradation, and the accelerated degradation refer to the degradation states of the battery cell 12 determined in terms of degradation speed. The normal degradation refers to a state in which the battery cell 12 does not experience performance degradation compared to the BOL (Beginning of Life) state. The linear degradation refers to a state in which the degradation of the battery cell 12 is not accelerated but progresses linearly. The accelerated degradation refers to a state in which the degradation of the battery cell 12 is gradually accelerated.

The voltage measurement unit 810 may measure the open circuit voltage of each of the plurality of battery cells 12 (S210). In addition, the voltage measurement unit 810 may transmit the measured open circuit voltage of the battery cells 12 to the degradation determining unit 830. Here, the open circuit voltage transmitted to the degradation determining unit 830 may be used as a factor for calculating the voltage fluctuation rate used to classify the degradation level of the battery cells 12.

Afterwards, the degradation determining unit 830 receives the open circuit voltage of each of the plurality of battery cells 12 transmitted from the voltage measurement unit 810, and may calculate the voltage fluctuation rate of each of the battery cells 12 according to the received open circuit voltage (S220). At this time, the degradation determining unit 830 may receive the open circuit voltage for each cycle, and calculate the voltage fluctuation rate of each of the battery cells 12 according to the received open circuit voltage.

Specifically, the degradation determining unit 830 may calculate the voltage fluctuation rate as the difference or ratio between the preset reference voltage and the open circuit voltage transmitted from the voltage measurement unit 810.

Specifically, the reference voltage may be the OCV of the battery cell 12 in the BOL state or a voltage value set theoretically/experimentally.

For example, it is assumed that the voltage measurement unit 810 measures the OCV of the battery cell 12 when the voltage of the battery cell 12 reaches the charge end voltage (or discharge end voltage). The reference voltage is the OCV of the battery cell 12 measured when the voltage of the battery cell 12 in the BOL state reaches the charge end voltage (or discharge end voltage).

As another example, the reference voltage may be preset to the OCV of a base cell preset to correspond to the battery cell 12 or a reference cell determined theoretically/experimentally through simulation, etc., rather than the battery cell 12 in the BOL state.

Assume that the voltage of the battery cell 12 of the kth battery is Vₖ [V] and the reference voltage is V_{ref} [V]. The degradation determining unit 830 may calculate the voltage fluctuation rate of the kth battery cell 12 by calculating the formula "Vₖ - V_{ref}" or "Vₖ ÷ V_{ref}".

When the degradation determining unit 830 calculates a voltage fluctuation rate, it may calculate the voltage change rate based on the calculated voltage fluctuation rate and the pre-stored voltage fluctuation rate data. Here, the voltage fluctuation rate data may be reference data for comparison with the calculated voltage fluctuation rate and may be data in which the calculated voltage fluctuation rate value is stored. Specifically, the pre-stored voltage fluctuation rate data may be data in which the voltage fluctuation rate calculated in the past by the degradation determining unit 830 is stored for each cycle. For example, when the current cycle is the sth cycle, the voltage fluctuation rate of the battery cell 12 from the first cycle to the s-1th cycle may be stored in the voltage fluctuation rate data.

The degradation determining unit 830 may calculate a voltage change rate for each preset cycle section based on the pre-stored voltage fluctuation rate data (S230). Here, the voltage change rate may include an average change rate or an instantaneous change rate of the voltage fluctuation rates.

Specifically, the degradation determining unit 830 may calculate a voltage change rate for the voltage fluctuation rate included in the cycle section selected based on the current cycle. Here, the voltage change rate may be an average change rate of the plurality of voltage fluctuation rates included in the selected cycle section or an instantaneous change rate of the voltage fluctuation rate of the current cycle in the predetermined cycle section. In other words, the voltage change rate is an indicator indicating an increase or decrease in the voltage fluctuation rate in the predetermined cycle section. Preferably, the voltage change rate may be calculated as 0, a positive number, or a negative number. For example, the degradation determining unit 830 assumes that the last 10 cycles including the current cycle are selected. The degradation determining unit 830 may calculate a voltage change rate of the voltage fluctuation rates for the 10 cycles.

The degradation determining unit 830 may determine the voltage increase/decrease pattern of the battery cell 12 based on the calculated voltage change rate (S240). The voltage increase/decrease pattern may include various patterns, such as a voltage increase pattern, a voltage decrease pattern, and a voltage constant pattern.

The degradation determining unit 830 may determine the degradation level as one of accelerated degradation, linear degradation, and decelerated degradation based on the voltage increase/decrease pattern of the battery cell 12 (S250).

Specifically, the degradation determining unit 830 may determine the voltage increase/decrease pattern as a voltage increase pattern when the voltage change rate is a positive change rate. The degradation determining unit 830 may determine the voltage increase/decrease pattern as a voltage constant pattern when the voltage change rate is 0. The degradation determining unit 830 may determine the voltage increase/decrease pattern as a voltage decrease pattern when the voltage change rate is a negative change rate.

Meanwhile, the degradation determining unit 830 may determine the degradation level of the battery cell 12 according to the voltage increase/decrease pattern. Specifically, the degradation determining unit 830 may determine the degradation level of the battery cell 12 as normal degradation when the voltage change rate is a positive change rate or 0, that is, when the voltage increase/decrease pattern is determined as a voltage increase pattern or a voltage constant pattern. This means that the open circuit voltage of the battery cell 12 is not degraded, and may mean that performance degradation of the first battery 200 is not occurring.

The degradation determining unit 830 may determine the degradation level of the battery cell 12 as either linear degradation or accelerated degradation if the voltage change rate is a negative change rate, that is, if the voltage increase/decrease pattern is determined as a voltage decrease pattern. At this time, the degradation determining unit 830 may determine accelerated degradation if the negative change rate has a negative change rate greater than the size of the preset change rate, and may determine linear degradation if the negative change rate has a negative change rate less than or equal to the size of the preset change rate. This may mean that the open circuit voltage of the battery cell 12 is gradually decreasing, and may mean that performance degradation of the first battery 200 is occurring. In particular, in the case of accelerated degradation, it may mean that performance degradation of the first battery 200 is occurring at a faster speed than the natural performance degradation of the first battery 200.

Here, in order to classify linear degradation and accelerated degradation, the degradation determining unit 830 may be configured to determine the degradation level of each battery cell 12 based on a voltage change rate and a preset reference change rate. That is, the preset reference voltage change rate is a reference change rate set to determine the degradation level as either accelerated degradation or linear degradation when the voltage increase/decrease pattern of the battery cell 12 is determined as a voltage decrease pattern.

In the battery module degradation state determining step S300, the battery management system 800 may diagnose the degradation state of the battery module 11.

In the battery module degradation state determining step S300, the degradation determining unit 830 may determine the degradation state of the battery module 11 based on the number or ratio of battery cells 12 whose degradation level is determined to be accelerated degradation among the plurality of battery cells 12 provided in the battery module 11.

Specifically, if the number of battery cells 12 among the plurality of battery cells 12 provided in the battery module 11, of which the degradation level is determined to be accelerated degradation, is equal to or greater than the first reference value or the ratio is equal to or greater than the first rate, the degradation determining unit 830 may determine the degradation state of the battery module 11 as an abnormal degradation state or a complete degradation state. Conversely, if the number of battery cells 12 among the plurality of battery cells 12, of which the degradation level is determined to be accelerated degradation, is less than the first reference value and the ratio is less than the first rate, the degradation determining unit 830 may determine the degradation state of the battery module 11 as a normal degradation state.

More specifically, when the number of battery cells 12 among the plurality of battery cells 12 provided in the battery module 11, of which the degradation level is determined to be accelerated degradation, is equal to or greater than the second reference value (set to be greater than the first reference value) or the ratio is equal to or greater than the second rate (set to be greater than the first rate), the degradation determining unit 830 may determine the degradation state of the battery module 11 as a complete degradation state. Conversely, when the number of battery cells 12 among the plurality of battery cells 12 provided in the battery module 11, of which the degradation level is determined to be accelerated degradation, is less than the second reference value and the ratio is less than the second rate, the degradation determining unit 830 may determine the degradation state of the battery module 11 as an abnormal degradation state.

That is, if 1) the number of battery cells 12 whose degradation level is determined to be accelerated degradation among the plurality of battery cells 12 provided in the battery module 11 is less than the first reference value and 2) the ratio is less than the first rate, the degradation determining unit 830 may determine the degradation state of the battery module 11 as a normal degradation state. In addition, if 1) the number of battery cells 12 whose degradation level is determined to be accelerated degradation among the plurality of battery cells 12 provided in the battery module 11 is greater than or equal to the first reference value and less than the second reference value and 2) the ratio is greater than or equal to the first rate and less than the second rate, the degradation determining unit 830 may determine the degradation state of the battery module 11 as an abnormal degradation state. And, if 1) the number of battery cells 12 among the plurality of battery cells 12 provided in the battery module 11, of which the degradation level is determined to be accelerated degradation, is equal to or greater than the second reference value or 2) the ratio is equal to or greater than the second rate, the degradation determining unit 830 may determine the degradation state of the battery module 11 as a complete degradation state.

For example, assume that 10 battery cells 12 are provided in each battery module 11, and that the first reference value is 4 or the first rate is preset to 40%, and that the second reference value is 7 or the second rate is preset to 70%. In this case, if the number of battery cells 12 whose degradation level is determined to be accelerated degradation is less than 4 among the 10 battery cells 12 provided in each of the plurality of battery modules 11, the degradation determining unit 830 may determine the degradation state of the corresponding battery module 11 as a normal degradation state. If the number of battery cells 12 whose degradation level is determined to be accelerated degradation is 4 or more and less than 7 among the 10 battery cells 12 provided in each of the plurality of battery modules 11, the degradation determining unit 830 may determine the degradation state of the corresponding battery module 11 as an abnormal degradation state. In addition, if the number of battery cells 12 whose degradation level is determined to be accelerated degradation is 7 or more among the 10 battery cells 12 provided in each of the plurality of battery modules 11, the degradation determining unit 830 may determine that the corresponding battery module 11 is in a complete degradation state.

Meanwhile, according to the embodiment, the degradation determining unit 830 may change and set the first reference value, the second reference value, the first rate, and the second rate based on the total driving distance of the vehicle.

Specifically, the degradation determining unit 830 may reduce and set the first reference value, the second reference value, the first rate, and the second rate based on the total driving distance of the hybrid electric vehicle 1 after the corresponding first battery 200 is installed. At this time, information on the total driving distance of the hybrid electric vehicle 1 may be stored in the memory of the electric control unit 700 or the memory unit 850 of the battery management system 800. As the hybrid electric vehicle 1 is driven, the total driving distance of the hybrid electric vehicle 1 gradually increases, and accordingly, the standard for determining the degradation state of the battery module 11 may be lowered. With this configuration, the degradation speed of the first battery 200 may be reduced, and the first battery 200 may be protected.

That is, the degradation determining unit 830 may more strictly determine the degradation state of the battery module 11 by reducing the size of the reference value used to determine the degradation state of the battery module 11 as the battery pack 10 is used more (as the total driving distance of the vehicle increases).

For example, as the magnitudes of the reference values such as the first value, the first rate, the second value, and the second rate decrease, the degradation state of the battery module 11 is more likely to be determined as a complete degradation state rather than an abnormal degradation state. Therefore, the degradation state of the battery module 11 may be determined more strictly.

In the battery pack upper limit power setting step S400, the battery management system 800 may determine the power mode of the first battery 200. Then, the upper limit power of the battery pack 10 may be set according to the determined power mode.

Specifically, in the battery pack upper limit power setting step S400, the degradation determining unit 830 may determine the power mode of the first battery 200 as a normal mode, a warning mode, or an emergency mode based on the degradation state of each battery module 11.

For example, if the degradation states of all of the plurality of battery modules 11 are normal degradation states, the degradation determining unit 830 may set the power mode of the first battery 200 to a normal mode. That is, if there is no battery module 11 whose degradation state is an abnormal degradation state or a complete degradation state among the plurality of battery modules 11, the degradation determining unit 830 may set the power mode of the first battery 200 to a normal mode. If there is at least one battery module 11 whose degradation state is an abnormal degradation state among the plurality of battery modules 11 and the remaining degradation states are normal degradation states, the degradation determining unit 830 may set the power mode of the first battery 200 to a warning mode. If there is at least one battery module 11 whose degradation state is a complete degradation state among the plurality of battery modules 11, the degradation determining unit 830 may set the power mode of the first battery 200 to an emergency mode.

As another example, if the ratio of battery modules 11 whose degradation state is an abnormal degradation state or a complete degradation state among the plurality of battery modules 11 is less than a preset third ratio, the degradation determining unit 830 may set the power mode of the first battery 200 to a normal mode. In addition, if the ratio of battery modules 11 whose degradation state is an abnormal degradation state or a complete degradation state among the plurality of battery modules 11 is greater than or equal to the third ratio and less than a preset fourth ratio, the degradation determining unit 830 may set the power mode of the first battery 200 to a warning mode. Here, the fourth ratio has a ratio value greater than the third ratio. In addition, if the ratio of battery modules 11 whose degradation state is an abnormal degradation state or a complete degradation state among the plurality of battery modules 11 is greater than or equal to the fourth ratio, the degradation determining unit 830 may set the power mode of the first battery 200 to an emergency mode. Meanwhile, the degradation determining unit 830 may adjust the sizes of the third ratio and the fourth ratio. For example, the degradation determining unit 830 may, but is not limited to, reduce the size of the third ratio and the fourth ratio as the number of charging cycles increases.

In the driving mode determining step (S700), the driving mode determining unit 750 may determine the driving mode of the hybrid electric vehicle 1 according to the power mode of the first battery 200.

The driving mode determining unit 750 may receive information on the degradation state of the battery module 11 and the power mode of the first battery 200 from the degradation determining unit 830. Furthermore, the driving mode determining unit 750 may determine the driving mode of the hybrid electric vehicle 1 according to the power mode of the first battery 200 (S700).

The driving mode determining unit 750 may control the driving mode to maintain the first speed and the second speed when the power mode of the first battery 200 is the normal mode. In addition, the driving mode determining unit 750 may control the driving mode by lowering the first speed and the second speed to the first reference ratio, respectively, when the power mode of the first battery 200 is the warning mode. In addition, the driving mode determining unit 750 may control the driving mode by lowering the first speed and the second speed to the second reference ratio, respectively, which is greater than the first reference ratio, when the power mode of the first battery 200 is the emergency mode.

In the EV driving mode, the driving mode determining unit 750 may determine that the driving mode up to the first speed of the hybrid electric vehicle 1 after starting is the EV driving mode, the driving mode determining unit 750 may determine that the driving mode from the first speed or higher is the HEV driving mode, and in the ENG driving mode, the driving mode determining unit 750 may determine that the driving mode from the second speed or higher is the ENG driving mode.

Hereinafter, reference will be made to FIGS. 29 to 31. FIGS. 29 to 31 illustrate the motor output amount and the engine output amount according to the speed of a hybrid electric vehicle in a normal mode, a warning mode, and an emergency mode, respectively. FIGS. 29 to 31 classify the EV mode, the HEV mode, and the ENG mode, which are distinguished according to the first speed and the second speed, respectively.

Referring to FIGS. 28 and 29, when the power mode of the first battery 200 is a normal mode, the first speed and the second speed may be maintained without changing. After starting the hybrid electric vehicle 1 in the EV mode, the motor output amount increases by the first battery 200 up to the first speed, and the engine output amount is maintained at 0. After the first speed, it transitions to the HEV mode, and the motor output amount and the engine output amount simultaneously increase up to the second speed. After the second speed, it transitions to the ENG mode, and the motor output amount decreases to 0, and the engine output amount increases.

Referring to FIGS. 28 and 30, when the power mode of the first battery 200 is the warning mode, the first speed and the second speed are variable. Specifically, the first speed and the second speed may each be lowered to the first reference ratio. The first speed and the second speed may each be lowered to the first reference ratio and set to the first speed_1 and the second speed_1. After starting the hybrid electric vehicle 1 in the EV mode, the motor output amount increases by the first battery 200 to the first speed_1, and the engine output amount is maintained at 0. After the first speed_1, it transitions to the HEV mode, and the motor output amount and the engine output amount simultaneously increase to the second speed_1. After the second speed_1, it transitions to the ENG mode, and the motor output amount decreases to 0, and the engine output amount increases.

Referring to FIGS. 28 and 31, when the power mode of the first battery 200 is the emergency mode, the first speed and the second speed are variable. Specifically, the first speed and the second speed may each be lowered to the second reference ratio. The first speed and the second speed may each be lowered to the second reference ratio and set to the first speed_2 and the second speed_2. The second reference ratio may be larger than the first reference ratio. Therefore, the first speed_2 and the second speed_2 may each be smaller than the first speed_1 and the second speed_1. After starting the hybrid electric vehicle 1 in the EV mode, the motor output amount increases to the first speed_2 by the first battery 200, and the engine output amount is maintained at 0. After the first speed_2, it transitions to the HEV mode, and the motor output amount and the engine output amount simultaneously increase to the second speed_2. After the second speed_2, it transitions to the ENG mode, and the motor output amount decreases to 0, and the engine output amount increases.

According to the hybrid electric vehicle 1 according to the present embodiment, the first speed and the second speed, which serve as the standards for the EV driving mode, the HEV driving mode, and the ENG driving mode, may be varied depending on the power mode of the first battery 200. That is, the worse the degradation state of the plurality of battery modules 11 included in the first battery 200, the more the driving mode of the hybrid electric vehicle 1 may be determined to reduce the use of the first battery 200. This has the advantage that the degradation of the first battery 200 may be delayed.

Hereinafter, a hybrid electric vehicle 2 according to another embodiment will be described. For configurations identical or similar to the hybrid electric vehicle 1 described above, duplicate descriptions or detailed descriptions will be omitted.

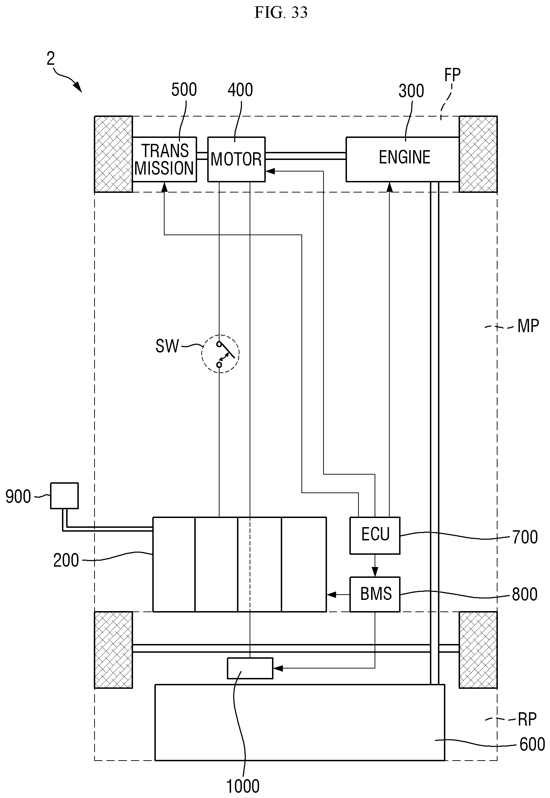

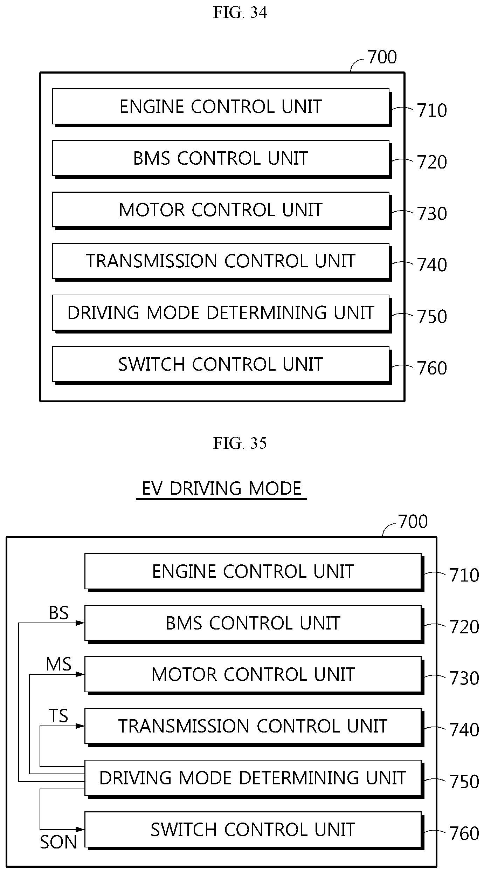

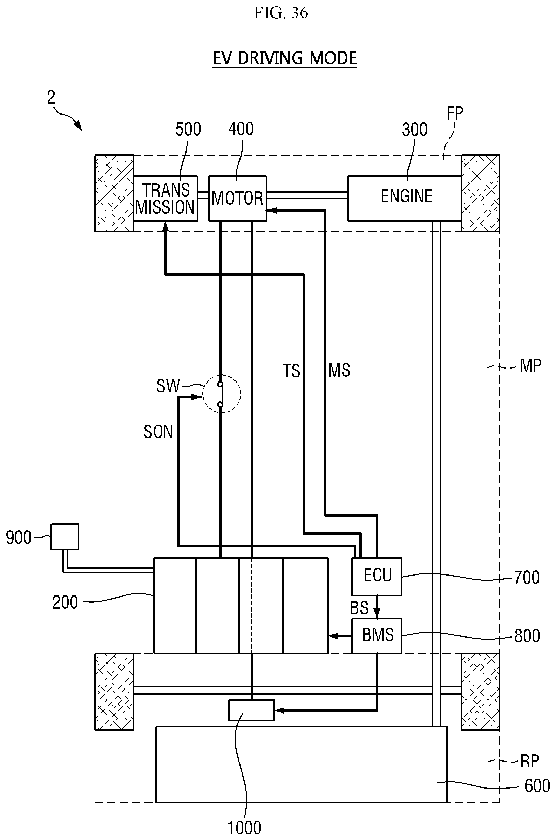

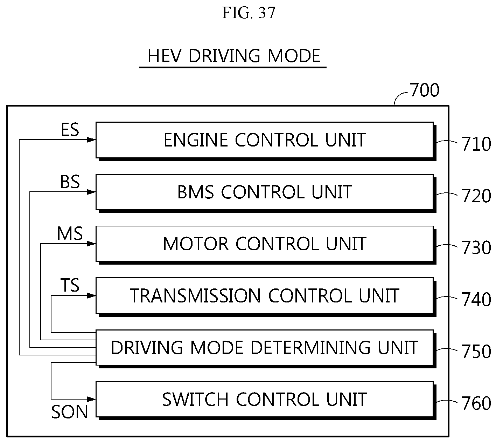

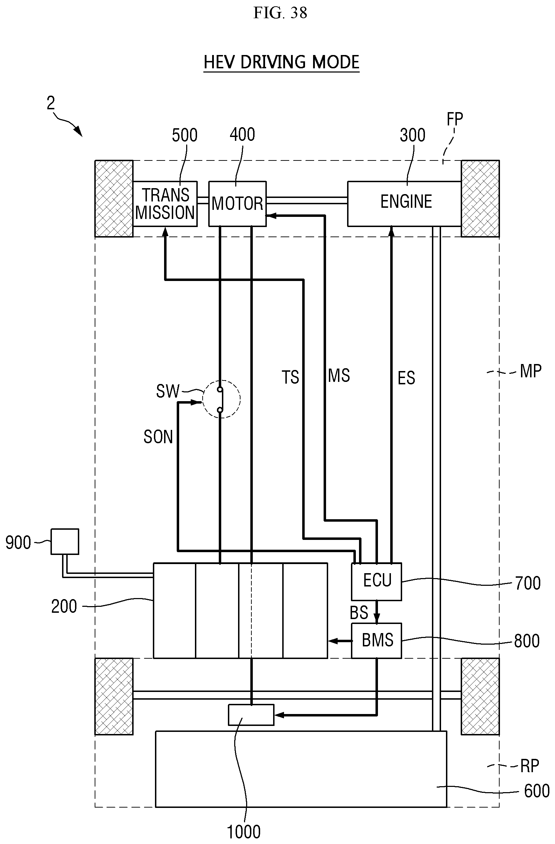

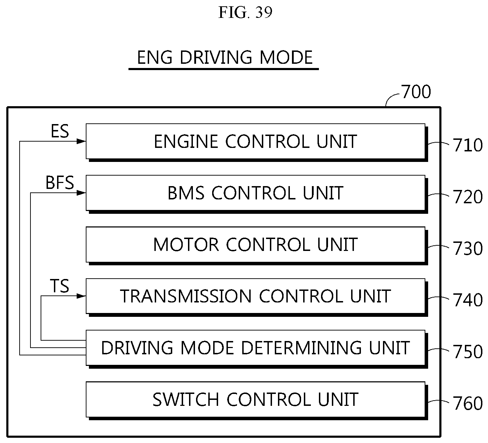

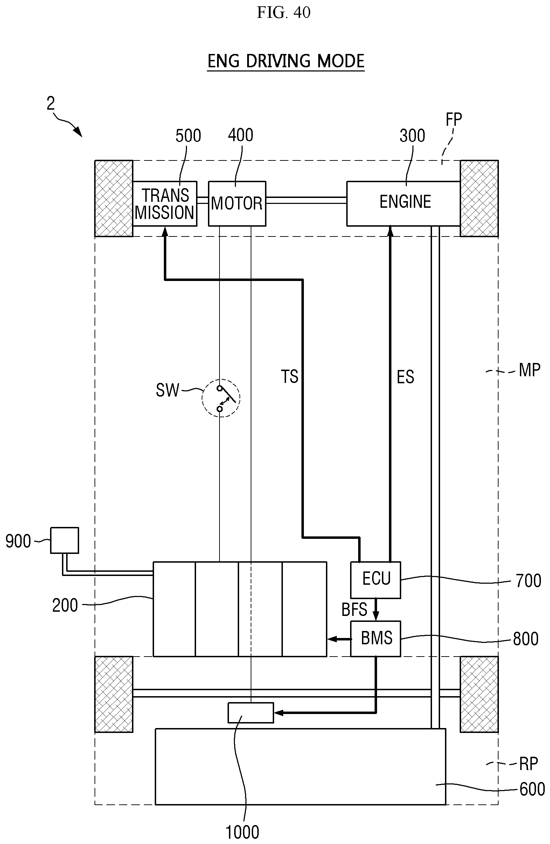

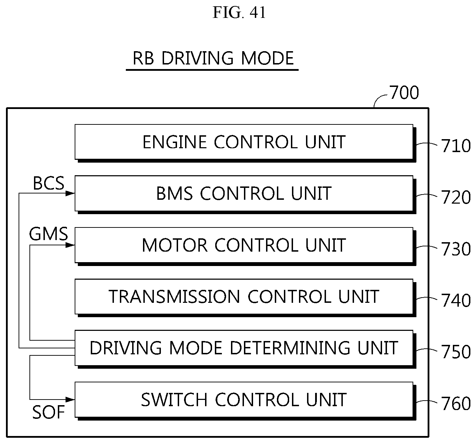

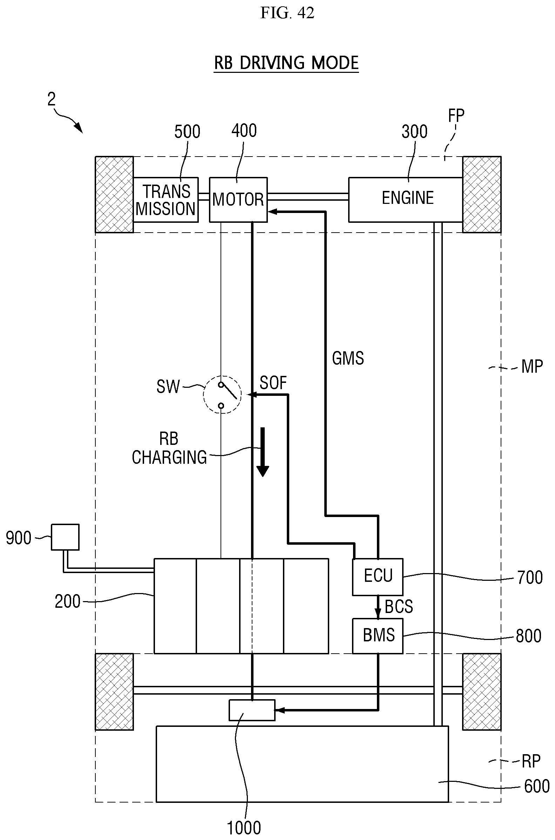

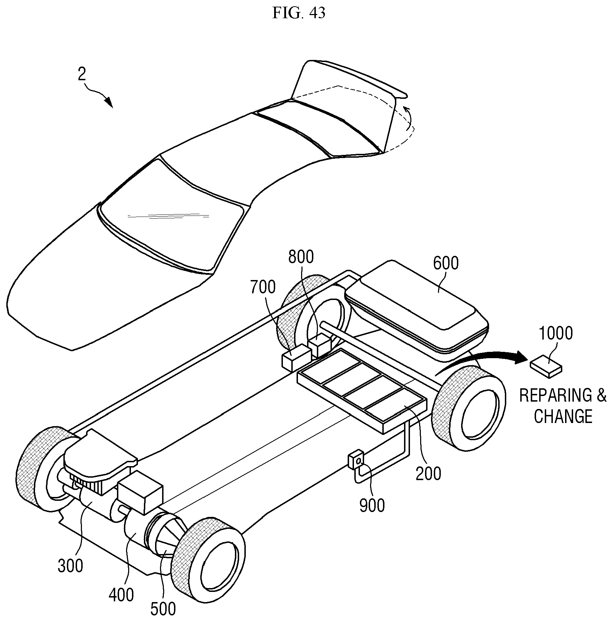

FIG. 32 is an exploded perspective view of a hybrid electric vehicle 2 according to another embodiment. FIG. 33 is a drawing showing in detail the configurations of the hybrid electric vehicle 2 according to FIG. 32. FIG. 34 is a drawing showing the specific configurations of the electric control unit 700 according to FIG. 33. FIG. 35 is a drawing showing the relationships between the components of the electric control unit 700 in an EV driving mode. FIG. 36 is a drawing showing the relationships between the components of the hybrid electric vehicle 2 in an EV driving mode. FIG. 37 is a drawing showing the relationships between the components of the electric control unit 700 in a HEV driving mode. FIG. 38 is a drawing showing the relationships between the components of the hybrid electric vehicle 2 in a HEV driving mode. FIG. 39 is a drawing showing the relationships between the components of the electric control unit 700 in an ENG driving mode. FIG. 40 is a diagram showing the relationships between components of a hybrid electric vehicle 2 in an ENG driving mode. FIG. 41 is a diagram showing the relationships between components of an electric control unit 700 in a RB driving mode. FIG. 42 is a diagram showing the relationships between components of a hybrid electric vehicle 2 in a RB driving mode. FIG. 43 is a schematic diagram showing repair or replacement of the secondary battery 1000 in the hybrid electric vehicle 2 according to FIG. 32.

Referring to FIGS. 32 to 43, the hybrid electric vehicle 2 differs from the hybrid electric vehicle 1 according to FIGS. 1 to 31 in that it may further include a second battery 1000. Although only one second battery 1000 is illustrated, this is not limited thereto and a plurality of second batteries 1000 may be provided. For example, N (a natural number greater than or equal to 1) or more second batteries 1000 may be provided.

The hybrid electric vehicle 2 may include a first battery 200, an engine (ENGINE, 300), a motor (MOTOR, 400), a transmission (TRANSMISSION, 500), a fuel tank 600, an electric control unit (ECU, 700), a battery management system (BMS, 800), a plug-in charger 900, and a second battery 1000.

The first battery 200 may be charged through the plug-in charger 900. The first battery 200 may be a plug-in charging type battery. The plug-in charger 900 may receive electric energy from an external electric charging device and supply the electric energy to the first battery 200 to charge the first battery 200. The first battery 200 may be connected to the motor 400. A switch SW may be arranged between the first battery 200 and the motor 400. The first battery 200 may be connected in one direction to the motor 400. In this specification, one-way connection may mean that the first battery 200 supplies electric energy to the motor 400, but does not receive electric energy from the motor 400.

The second battery 1000 may be connected to the motor 400. The second battery 1000 may be a regenerative braking charging battery that is charged in the regenerative braking mode. The second battery 1000 may be bidirectionally connected to the motor 400. In this specification, the bidirectional connection means that the second battery 1000 may not only supply the charged electric energy to the motor 400, but also receive the electric energy recovered from the motor 400 in the regenerative braking mode.

The electric control unit 700 may control the engine 300, the motor 400, the transmission 500, and the battery management system 800. The electric control unit 700 may control the on/off of the switch SW.

The battery management system 800 may control the first battery 200 and the second battery 1000. The battery management system 800 may control the output and charging of the first battery 200 and the output and charging of the second battery 1000. The battery management system 800 is illustrated as being separately disposed from the first battery 200 and the second battery 1000, but is not limited thereto and may be disposed within the first battery 200. For convenience of explanation, the following description will focus on the battery management system 800 being disposed separately outside the first battery 200.

The electric control unit 700 may include an engine control unit 710, a BMS control unit 720, a motor control unit 730, a transmission control unit 740, a driving mode determining unit 750, and a switch control unit 760.

The engine control unit 710 may control the engine 300, the BMS control unit 720 may control the battery management system (BMS), the motor control unit 730 may control the motor 400, the transmission control unit 740 may control the transmission 500, and the switch control unit 760 may control the on/off of the switch SW.

The driving mode determining unit 750 may determine the driving mode of the hybrid electric vehicle 2. For example, the driving mode determining unit 750 may determine whether the hybrid electric vehicle 2 is in the EV driving mode (or EV mode), the HEV driving mode (or HEV mode), the ENG driving mode (or ENG mode), or the RB driving mode.

In the EV driving mode, when the driver steps on the accelerator after starting, the engine clutch is opened and the motor 400 is driven using the power of the first battery 200 and the second battery 1000. The power of the motor 400 is transmitted through the transmission 500 and the final reduction gear to move the wheels.

Specifically, in the EV driving mode, the driving mode determining unit 750 may determine that the hybrid electric vehicle 2 after starting is in the EV driving mode up to the first speed after starting.

The driving mode determining unit 750 may turn on the BMS control unit 720, the motor control unit 730, the transmission control unit 740, and the switch control unit 760.

The driving mode determining unit 750 may generate a battery control signal BS and transmit it to the BMS control unit 720, generate a motor control signal MS and transmit it to the motor 400, generate a transmission control signal TS and transmit it to the transmission 500, and generate a switch on signal SON and transmit it to the switch control unit 760. In FIG. 35, the driving mode determining unit 750 is exemplified as generating and transmitting control signals BS, MS, TS, SON to the BMS control unit 720, the motor control unit 730, the transmission control unit 740, and the switch control unit 760, respectively, but is not limited thereto. That is, each of the BMS control unit 720, the motor control unit 730, the transmission control unit 740, and the switch control unit 760 may generate the above-described control signals BS, MS, TS, SON under the control of the driving mode determining unit 750. For convenience of explanation, the following description will focus on the driving mode determining unit 750 generating and transmitting control signals BS, MS, TS, SON to the BMS control unit 720, motor control unit 730, transmission control unit 740, and switch control unit 760, respectively.

The BMS control unit 720 may transmit the generated battery control signal BS to the first battery 200 and the second battery 1000. The first battery 200 and the second battery 1000 may supply power (or electric energy) to the motor 400 based on the battery control signal BS of the BMS control unit 720.

The motor control unit 730 may transmit the generated motor control signal MS to the motor 400. The motor 400 may operate based on the transmitted motor control signal MS.

The transmission control unit 740 may transmit the generated transmission control signal TS to the transmission 500. The transmission 500 may operate based on the transmitted transmission control signal TS.

The switch control unit 760 may turn on the switch SW based on the generated switch-on signal (SON). As a result, the first battery 200 and the motor 400 are electrically connected, and the power of the first battery 200 may be transmitted to the motor 400.

The HEV driving mode may be a driving mode in which the speed of the hybrid electric vehicle 2 is higher than or equal to the first speed. In the HEV driving mode, the engine 300 and the motor 400 drive the hybrid electric vehicle 2 together. In the HEV driving mode, the power of the engine 300 and the motor 400 moves the wheels through the transmission 500 and the final reduction gear.

Specifically, in the HEV driving mode, the driving mode determining unit 750 may determine that the driving mode is the HEV driving mode from the first speed or higher.

The driving mode determining unit 750 may turn on the engine control unit 710, the BMS control unit 720, the motor control unit 730, the transmission control unit 740, and the switch control unit 760.

The driving mode determining unit 750 may generate an engine control signal ES and transmit it to the engine control unit 710, generate a battery control signal BS and transmit it to the BMS control unit 720, generate a motor control signal MS and transmit it to the motor 400, generate a transmission control signal TS and transmit it to the transmission 500, and generate a switch on signal SON and transmit it to the switch control unit 760. Although the driving mode determining unit 750 is exemplified as generating and transmitting control signals ES, BS, MS, TS, SON to the engine control unit 710, the BMS control unit 720, the motor control unit 730, the transmission control unit 740, and the switch control unit 760, respectively, it is not limited thereto. That is, each of the engine control unit 710, the BMS control unit 720, the motor control unit 730, the transmission control unit 740, and the switch control unit 760 may generate the above-described control signals MS, BS, MS, TS, SON under the control of the driving mode determining unit 750. For convenience of explanation, the following description will focus on the driving mode determining unit 750 generating and transmitting control signals MS, BS, MS, TS, SON to the engine control unit 710, BMS control unit 720, motor control unit 730, transmission control unit 740, and switch control unit 760, respectively.

The BMS control unit 720 may transmit the generated battery control signal BS to the first battery 200 and the second battery 1000. The first battery 200 and the second battery 1000 may supply power (or electric energy) to the motor 400 based on the battery control signal BS of the BMS control unit 720.

The switch control unit 760 may turn on the switch SW based on the generated switch-on signal SON. As a result, the first battery 200 and the motor 400 are electrically connected, and the power of the first battery 200 may be transmitted to the motor 400.

The transmission control unit 740 may transmit the generated transmission control signal TS to the transmission 500. The transmission 500 may operate based on the transmitted transmission control signal TS.

The ENG driving mode may be a driving mode when the speed of the hybrid electric vehicle 2 is higher than or equal to the second speed. In the ENG driving mode, only the engine 300 drives the hybrid electric vehicle 2. In the ENG driving mode, the power of the engine 300 moves the wheels through the transmission 500 and the final reduction gear.

Specifically, in the ENG driving mode, the driving mode determining unit 750 may determine that the driving mode is the ENG driving mode from the second speed or higher.

The driving mode determining unit 750 may turn on the engine control unit 710 and the transmission control unit 740, and turn off the BMS control unit 720 and the motor control unit 730. In the ENG driving mode, since the power supply to the first battery 200 and the second battery 1000 is cut off by the BMS control unit 720, the switch SW may not need to be turned off, but is not limited thereto, and the switch SW may be turned off by the driving mode determining unit 750.

The driving mode determining unit 750 may generate an engine control signal ES and transmit it to the engine control unit 710, generate a battery off signal BFS and transmit it to the BMS control unit 720, and generate a transmission control signal TS and transmit it to the transmission 500. Although the driving mode determining unit 750 does not illustrate as generating a motor off signal to turn off the motor 400 and transmitting it to the motor control unit 730, if the driving mode determining unit 750 does not transmit the motor control signal MS to the motor control unit 730, the motor 400 may be turned off. However, the present disclosure is not limited thereto, and the driving mode determining unit 750 may separately generate a motor off signal to turn off the motor 400 and transmit it to the motor control unit 730, and the motor 400 may be turned off based on the motor off signal received from the motor control unit 730.

Although it is exemplified that the driving mode determining unit 750 generates and transmits control signals ES, BFS, TS to the engine control unit 710, the BMS control unit 720, and the transmission control unit 740, respectively, it is not limited thereto. That is, each of the engine control unit 710, the BMS control unit 720, and the transmission control unit 740 may generate the above-described control signals BS, BFS, TS under the control of the driving mode determining unit 750. In the following, for the convenience of explanation, the driving mode determining unit 750 will be described focusing on generating and transmitting control signals ES, BFS, TS to the engine control unit 710, the BMS control unit 720, and the transmission control unit 740, respectively.

The engine control unit 710 may transmit the generated engine control signal ES to the engine 300. The engine 300 may operate based on the transmitted engine control signal ES.

The BMS control unit 720 may transmit the generated battery off signal BFS to the first battery 200 and the second battery 1000. The first battery 200 and the second battery 1000 may not provide power to the motor 400 based on the battery off signal BFS of the BMS control unit 720.

The transmission control unit 740 may transmit the generated transmission control signal TS to the transmission 500. The transmission 500 may operate based on the transmitted transmission control signal TS.

The RB driving mode may be a mode that is activated in the braking mode of the hybrid electric vehicle 2.

The RB driving mode may refer to a mode that recovers some of the kinetic energy (or mechanical power) lost in the braking mode and converts it into electrical energy (or electric power). However, since the RB driving mode is a mode that is activated in a sudden environment, the conversion of kinetic energy into electrical energy and the charging of the electric energy into the battery in the RB driving mode may occur intermittently. However, if the battery is charged intermittently, the performance and lifespan of the battery may deteriorate.

In the RB driving mode, the motor 400 may operate as a generator instead of converting electric energy (or electric power) into kinetic energy (or mechanical power). That is, the motor 400 may convert kinetic energy (or mechanical power) into electric energy (or electric power).

Specifically, in the RB driving mode, the driving mode determining unit 750 may determine that the hybrid electric vehicle 2 is in the RB driving mode when braking.

The driving mode determining unit 750 may turn on the BMS control unit 720, the motor control unit 730, and the switch control unit 760, and turn off the transmission control unit 740 and the engine control unit 710.

The driving mode determining unit 750 may generate a battery charging signal BCS and transmit it to the BMS control unit 720, generate a motor generating signal GMS and transmit it to the motor control unit 730, and generate a switch off signal SOF and transmit it to the switch control unit 760. Although the driving mode determining unit 750 does not illustrate as generating a motor off signal for turning off the engine 300 and transmitting it to the engine control unit 710, and generating a transmission off signal for turning off the transmission 500 and transmitting it to the transmission control unit 740, if the driving mode determining unit 750 does not transmit the engine control signal ES and the transmission control signal TS to the engine control unit 710 and the transmission control unit 740, respectively, the engine 300 and the transmission 500 may be turned off. However, without being limited thereto, the driving mode determining unit 750 may separately generate an engine off signal and a transmission off signal to turn off the engine 300 and the transmission 500 and transmits them to the engine control unit 710 and the transmission control unit 740, respectively, and the engine 300 and the transmission 500 may be turned off based on the engine off signal and the transmission off signal received from the engine control unit 710 and the transmission control unit 740, respectively.

Although it is exemplified that the driving mode determining unit 750 generates and transmits the control signals BCS, GMS, SOF to the BMS control unit 720, the motor control unit 730, and the switch control unit 760, it is not limited thereto. That is, the BMS control unit 720, the motor control unit 730, and the switch control unit 760 may generate the above-described control signals BCS, GMS, SOF, respectively, under the control of the driving mode determining unit 750. In the following, for the convenience of explanation, the driving mode determining unit 750 will be described focusing on generating and transmitting the control signals BCS, GMS, SOF to the BMS control unit 720, the motor control unit 730, and the switch control unit 760, respectively.

The BMS control unit 720 may transmit the generated battery charging signal BCS to the second battery 1000. The second battery 1000 may charge (RB CHARGING) the electric energy (or electric power) generated from the motor 400 based on the transmitted battery charging signal BCS. It is illustrated that the BMS control unit 720 does not transmit the generated battery charging signal BCS to the first battery 200. However, the present disclosure is not limited thereto, and the BMS control unit 720 may transmit the generated battery charging signal BCS to the first battery 200. In this case, as described above, since the switch SW between the first battery 200 and the motor 400 is turned off by the switch control unit 760, in the RB driving mode, the first battery 200 is not electrically connected to the motor 400, and the electric energy (or electric power) generated by the motor 400 may not be charged to the first battery 200.

The motor control unit 730 may transmit the generated motor generating signal GMS to the motor 400. The motor 400 may convert the motor 400 into a generator and operate it based on the motor generating signal GMS of the motor control unit 730. The motor 400 may recover some of the kinetic energy (or mechanical power) lost in the RB braking mode and convert it into electric energy (or electric power). The motor 400 may transmit the converted electric energy (or electric power) to the second battery 1000.

The hybrid electric vehicle 2 according to another embodiment may include a first battery 200 that is charged by a plug-in charging method as described above and a second battery 1000 that is independently arranged from the first battery 200, and the second battery 1000 may be a battery that is charged by a regenerative braking charging method in the RB driving mode. In other words, the first battery 200 supplies electric energy (or electric power) to the motor 400, but does not receive electric energy recovered by the motor 400, so that it may be connected in one direction to the motor 400, and the second battery 1000 may be connected in two directions to the motor 400. The RB driving mode is a mode that recovers some of the kinetic energy lost in the braking mode and converts it into electric energy, and since it is a mode that is activated in a sudden environment, the conversion of kinetic energy into electric energy and the charging of the electric energy into the battery in the RB driving mode may occur intermittently. If the battery is charged intermittently, the performance and lifespan of the battery may deteriorate.

The hybrid electric vehicle 2 according to another embodiment may be configured such that the first battery 200, which primarily supplies electric energy to the motor 400, does not receive electric energy recovered by the motor 400 in the RB driving mode, while the electric energy recovered by the motor 400 is entirely charged to the separately provided second battery 1000. This minimizes degradation in the performance and lifespan of the first battery 200.

In addition, the first battery 200 may have a large area due to its large capacity. On the other hand, since the second battery 1000 is charged in the RB driving mode, it may have a smaller capacity and area compared to the first battery 200. Therefore, the installation location of the second battery 1000 may be much freer than that of the first battery 200. For example, as described above, the first battery 200 must be located in the middle portion MP of the hybrid electric vehicle 2 due to its large capacity and area. If the first battery 200 is located in the middle portion MP of the hybrid electric vehicle 2, the entire lower frame of the hybrid electric vehicle 2 must be removed to extract the first battery 200, which may make repair and replacement of the first battery 200 very difficult. However, since the installation location of the second battery 1000 is much freer than that of the first battery 200, it may be located in the rear portion RP of the hybrid electric vehicle 2. Although the second battery 1000 is exemplified as being located between the rear wheel and the fuel tank 600, it is not limited thereto. That is, since the second battery 1000 may be easily extracted from the hybrid electric vehicle 2, even if the performance and lifespan of the second battery 1000 deteriorate, it may be easily replaced and repaired.

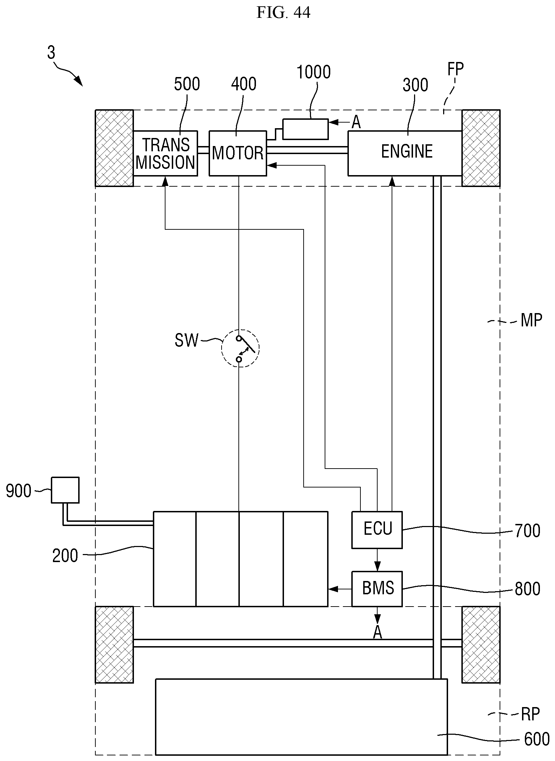

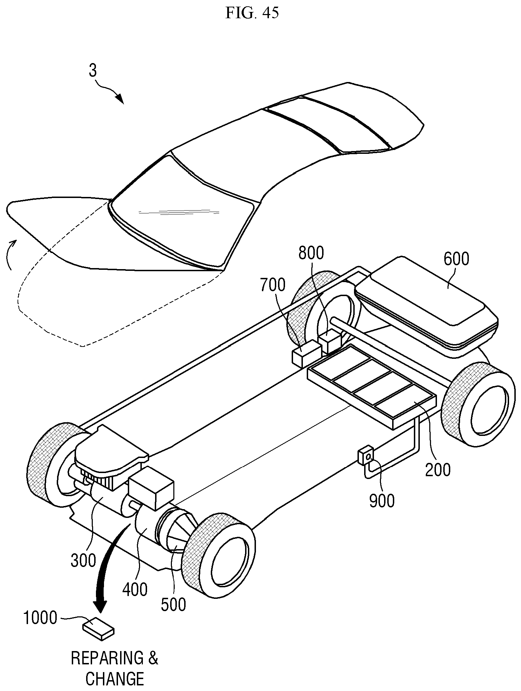

FIG. 44 is a diagram showing in detail the components of a hybrid electric vehicle 3 according to another embodiment. FIG. 45 is a schematic diagram showing repair or replacement of a secondary battery 1000 in the hybrid electric vehicle 3 according to FIG. 44.

Referring to FIGS. 44 and 45, the second battery 1000 of the hybrid electric vehicle 3 according to another embodiment may be located in the front portion FP. And, as described above, the second battery 1000 may be connected to the motor 400 and the battery management system (BMS, 800). When the bonnet of the hybrid electric vehicle 3 is opened, the second battery 1000 may be easily extracted from the hybrid electric vehicle 3. Accordingly, in the RB driving mode, even if the performance and lifespan of the second battery 1000 being charged are degraded, it may be easily replaced (CHANGE) and repaired (REPAIRING).

The embodiments of the present disclosure described above are not implemented only through the apparatus and method, but may also be implemented through a program that realizes a function corresponding to the configuration of the embodiments of the present disclosure or a recording medium on which the program is recorded, and such implementation may be easily implemented by an expert in the technical field to which the present disclosure belongs based on the above description of the embodiment.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

All simple modifications or changes of the present disclosure fall within the scope of the present disclosure, and the specific scope of protection of the present disclosure will be made clear by the appended claims.

### (Explanation of reference signs)

1, 2, 3: vehicle, hybrid electric vehicle
10: battery pack
11: battery module
12: battery cell
15, 800: BMS, battery management system
20, 700: ECU, electric control unit
21: driving control unit
30: motor control unit
40, 400: motor
50: low-voltage DC-DC converter
60: low-voltage battery
100: battery power setting apparatus
110: measurement unit
120: control unit
130: storage unit
200: first battery
300: engine
500: transmission
600: fuel tank
900: plug-in charger
1000: second battery

## Claims

1. A battery power setting apparatus for setting an upper limit power of a battery pack including one or more battery modules, each of which includes one or more battery cells, the battery power setting apparatus comprising:
a measurement unit configured to measure a voltage of each of the battery cells under a preset condition; and
a control unit configured to determine a degradation level of each of the battery cells based on the voltage measured by the measurement unit, determine a degradation state of each of the battery modules based on the degradation level of the corresponding battery cell, and set an upper limit power of the battery pack according to the determined degradation state of the battery module.

2. The battery power setting apparatus according to claim 1,
wherein the control unit is configured to:
determine the degradation level of the battery cell as normal degradation, linear degradation, or accelerated degradation, and
determine the degradation state of each of the battery modules as a normal degradation state or an abnormal degradation state.

3. The battery power setting apparatus according to claim 2,
wherein the control unit is configured to determine a power mode of the battery pack as a normal mode, a warning mode, or an emergency mode based on the number or ratio of battery modules whose degradation state is determined as the abnormal degradation state.

4. The battery power setting apparatus according to claim 3,
wherein the power mode is set so that a corresponding power decreases in the order of the normal mode, the warning mode, and the emergency mode, and
wherein the control unit is configured to set the power corresponding to the determined power mode to the upper limit power of the battery pack.

5. The battery power setting apparatus according to claim 3,
wherein the control unit is configured to set the upper limit power of the battery pack by weighting and adding a weight corresponding to the degradation state determined to correspond to an output enable power of each of the battery modules.

6. A battery pack, comprising the battery power setting apparatus according to any one of claims 1 to 5.

7. A vehicle, comprising:
the battery power setting apparatus according to any one of claims 1 to 5;
a battery pack having an upper limit power set by the battery power setting apparatus; and
a driving control unit configured to control an output of the battery pack based on the upper limit power of the battery pack set by the battery power setting apparatus.

8. The vehicle according to claim 7,
wherein the driving control unit is configured to limit a maximum output of a motor connected to the battery pack to an output corresponding to the upper limit power.

9. The vehicle according to claim 8,
wherein the driving control unit is configured to limit the maximum output of the motor to correspond to the upper limit power after a preset time so as to correspond to a power mode of the battery pack, when an output request exceeding the upper limit power is input.

10. The vehicle according to claim 8,
wherein the driving control unit is configured to obtain weather information, determine a weight corresponding to the obtained weather information from a preset table, add the determined weight to an output corresponding to the upper limit power, and limit an output of the motor to the weight-added output or less.

11. The vehicle according to claim 8,
wherein the driving control unit is configured to obtain information about a target driving distance to a destination, a capacity of the battery pack, and a driving pattern of the vehicle, and control an operation of the motor based on the upper limit power, the capacity of the battery pack, the target driving distance, and the driving pattern.

12. The vehicle according to claim 11,
wherein the driving control unit is configured to:
calculate a first output value corresponding to the upper limit power,
calculate a second output value to drive the target driving distance based on the capacity of the battery pack and the driving pattern, and
limit the output of the motor to a smaller value of the first output value and the second output value or less.

13. The vehicle according to claim 12,
wherein the driving control unit is configured to calculate the second output value so that the capacity of the battery pack becomes a preset threshold capacity or above when the target driving distance is reached, taking into account the driving pattern.

14. The vehicle according to claim 7,
wherein the driving control unit is configured to control an output of the battery pack so that power is supplied to an essential element first within a range of the upper limit power, and power is supplied to an auxiliary element within a range of a remaining power.

15. The vehicle according to claim 7,
wherein the battery power setting apparatus is configured to determine a power mode of the battery pack based on the determined degradation state of the battery module, and
wherein the driving control unit is configured to control power distribution to the essential element and the auxiliary element based on the power mode of the battery pack.
